# FASCICULE DE BREVET EUROPEEN

(11) **EP 3 750 189 B1**
(45) Date de publication et mention de la délivrance du brevet: **19.07.2023**
(21) Numéro de dépôt: 19707440.4
(22) Date de dépôt: 01.02.2019
(51) Int. Cl.: H01L 27/15

(54) **DISPOSITIF OPTOÉLECTRONIQUE AVEC DES COMPOSANTS ÉLECTRONIQUES AU NIVEAU DE LA FACE ARRIÈRE DU SUBSTRAT ET PROCÉDÉ DE FABRICATION**
OPTOELEKTRONISCHE VORRICHTUNG MIT ELEKTRONISCHEN BAUELEMENTEN AUF DER RÜCKSEITE DES SUBSTRATS UND HERSTELLUNGSVERFAHREN
OPTOELECTRONIC DEVICE WITH ELECTRONIC COMPONENTS ON THE REAR FACE OF THE SUBSTRATE AND METHOD OF PRODUCTION

(30) Priorité: 06.02.2018 FR 1850975
(43) Date de publication de la demande: 16.12.2020
(73) Titulaire: Aledia, 38130 Echirolles (FR)
(72) Inventeur: ROBIN, Ivan-Christophe, 38000 Grenoble (FR); CHARBONNIER, Matthieu, 38600 Fontaine (FR); HUGON, Xavier, 38470 Teche (FR); DORNEL, Erwan, 38800 Champagnier (FR)
(74) Mandataire: Germain Maureau
(86) Numéro de dépôt international: PCT/FR2019/050227
(87) Numéro de publication internationale: WO 2019/155146

(56) Documents cités:
- EP-A1- 3 136 438
- WO-A1-2013/092304
- WO-A1-2015/044619
- WO-A1-2017/042512
- WO-A1-2017/042513
- FR-A1- 3 023 066
- US-A- 5 789 766
- US-A1- 2009 242 910
- US-A1- 2014 367 705

## Description

La présente invention concerne un dispositif optoélectronique à diodes électroluminescentes, par exemple constitutif d'un écran d'affichage ou d'un dispositif de projection d'images.

L'invention concerne aussi un procédé de fabrication d'un dispositif optoélectronique à diodes électroluminescentes.

De manière connue, un dispositif optoélectronique à diodes électroluminescentes permet d'effectuer la conversion d'un signal électrique en un rayonnement électromagnétique.

Il existe des dispositifs optoélectroniques, notamment des écrans d'affichage ou des dispositifs de projection d'images, comprenant des diodes électroluminescentes à base de matériaux semiconducteurs comprenant un empilement de couches semi-conductrices ou des éléments tridimensionnels comportant majoritairement au moins un élément du groupe III et un élément du groupe V, appelé par la suite composé III-V, notamment le nitrure de gallium (GaN), le nitrure de gallium et d'indium (GaInN) et le nitrure de gallium et d'aluminium (GaAIN).

Un pixel d'une image correspond à l'élément unitaire de l'image affichée par un écran d'affichage ou projetée par un dispositif de projection. Lorsque le dispositif optoélectronique est un écran d'affichage d'images monochromes, il comprend en général une seule source lumineuse pour l'affichage de chaque pixel de l'image. Lorsque le dispositif optoélectronique est un écran d'affichage d'images en couleur ou un dispositif de projection d'images en couleur, il comprend en général pour l'affichage de chaque pixel d'image au moins trois composants d'émission et/ou de régulation de l'intensité lumineuse, également appelés sous-pixels d'affichage, qui émettent chacun un rayonnement lumineux sensiblement dans une seule couleur (par exemple, le rouge, le vert, et le bleu). La superposition des rayonnements émis par ces trois sous-pixels d'affichage fournit à l'observateur la sensation colorée correspondant au pixel de l'image affichée. On appelle dans ce cas pixel d'affichage l'ensemble formé par les trois sous-pixels utilisés pour l'affichage d'un pixel d'image.

Chaque sous-pixel est généralement constitué d'un ensemble composé d'une ou plusieurs diodes électroluminescentes, un dispositif optoélectronique comprenant ainsi une pluralité de tels ensembles de diodes électroluminescentes en vue de la constitution des différents sous-pixels.

Pour fabriquer chaque pixel, une première solution consiste à prévoir un ensemble de diodes aptes à émettre de la lumière rouge, un autre ensemble de diodes aptes à émettre de la lumière verte et un autre ensemble apte à émettre de la lumière bleue. Mais ce type de conception nécessite de fabriquer les diodes d'une couleur donnée sur un même substrat, lequel est ensuite découpé afin de délimiter des dispositifs individuels. Chaque pixel est alors obtenu par reconstruction afin d'associer les dispositifs individuels de manière à disposer des trois couleurs.

Une solution alternative consiste à prévoir que toutes les diodes d'un pixel soient aptes à émettre dans une couleur donnée, l'obtention des sous-pixels émettant dans les deux autres couleurs étant obtenue par l'intermédiaire de convertisseurs de couleur.

Les différents sous-pixels ainsi obtenus par reconstruction ou à l'aide de convertisseurs de couleur sont ensuite disposés dans un boitier pour protéger les diodes électroluminescentes, lequel boitier est généralement fixé à un support, tel qu'un circuit imprimé.

Il peut notamment être souhaitable d'associer à chaque ensemble de diodes électroluminescentes, un circuit électronique de contrôle dont le rôle est de contrôler les diodes électroluminescentes de cet ensemble, par exemple afin de réguler l'émission de chaque sous-pixel de chaque pixel d'image. Il s'agit plus généralement, par exemple, d'un circuit de commande de l'alimentation des diodes électroluminescentes, d'un circuit de protection des diodes électroluminescentes contre les décharges électrostatiques ou d'un circuit de détection de la température des diodes électroluminescentes.

Ces circuits, qui peuvent comprendre quelques transistors (par exemple dans une quantité comprise entre 2 et 100) et d'éventuelles capacités (dans une quantité comprise entre 0 et 6) par diode électroluminescente, peuvent être connectés aux diodes électroluminescentes par une technique d'hybridation. Dans cette technique, les circuits électroniques sont d'abord fabriqués sur un deuxième substrat, séparément du dispositif optoélectronique, puis assemblés au dispositif optoélectronique, par exemple en étant fixés au support et connectés au boitier.

Cette technique connue est problématique car l'encombrement dû aux circuits électroniques peut être important. Elle induit un coût élevé en raison de l'obligation d'utiliser un deuxième substrat. Elle nécessite de disposer d'un procédé d'hybridation présentant un pas correspondant au pas de la matrice des diodes électroluminescentes. Le procédé comprend, en plus de la fabrication du dispositif optoélectronique, des étapes distinctes de fabrication des circuits électroniques et des étapes de connexion des circuits électroniques au dispositif optoélectronique. Ces étapes représentent un coût de fabrication.

Une autre solution consiste à intégrer les composants des circuits électroniques sur la face du substrat qui porte les diodes électroluminescentes, par exemple à l'image de la solution décrite dans le document WO2015/044619A1 au nom de la Demanderesse. Mais cette solution induit une perte importante de place du côté des diodes électroluminescentes en raison de la place consommée par l'implantation des circuits électroniques entre les diodes électroluminescentes. Il en résulte de cette perte de place que cette technique n'est pas parfaitement adaptée à la construction d'écran d'affichage où il est classiquement recherché une résolution la meilleure possible.

Le recours à des circuits électroniques utilisant des transistors en couches minces, connus dans le domaine concerné sous l'appellation « TFT » pour « Thin Film Transistor » selon la terminologie anglo-saxonne appropriée, ne permet pas de résoudre ces problématiques car des transistors de cette nature ne peuvent pas être associés à des pixels de petites tailles.

Il est aussi connu de l'état de la technique antérieure les documents FR 3 023 066 A1, EP 3 136 438 A1, US 2014/0367705 A1 et WO 2017/042513 A1.

La présente invention vise à résoudre tout ou partie des inconvénients présentés ci-avant.

Dans ce contexte, il existe un besoin de fournir une solution répondant à au moins l'un des objectifs listés ci-après :
- réduire l'encombrement du dispositif optoélectronique ;
- simplifier la fabrication et réduire les coûts ;
- favoriser l'obtention d'une bonne résolution conférée par le dispositif optoélectronique et permettre de recourir à des pixels de petites tailles.

Au moins l'un de ces objectifs peut être atteint grâce à la fourniture d'un dispositif optoélectronique comprenant un substrat monolithique délimitant une première face et une deuxième face opposées l'une par rapport à l'autre suivant l'épaisseur du substrat, et une pluralité d'ensembles de diodes électroluminescentes où les diodes électroluminescentes d'un ensemble donné sont associées électriquement entre elles et chaque ensemble de diodes électroluminescentes comprend :
une pluralité de diodes électroluminescentes agencées, du côté de la première face du substrat, sur une première portion correspondante du substrat, chaque diode électroluminescente comprenant des éléments semiconducteurs dont une première portion dopée, une partie active et une seconde portion dopée;
une première électrode inférieure en contact avec les premières portions dopées de toutes les diodes électroluminescentes de l'ensemble ;
une seconde électrode supérieure en contact avec les secondes portions dopées de toutes les diodes électroluminescentes de l'ensemble, la seconde électrode supérieure étant électriquement isolée par rapport à la première électrode inférieure et comprenant une couche d'électrode conductrice supérieure recouvrant au moins une partie de chaque diode électroluminescente dudit ensemble pour prendre un contact avec chaque diode ;
un composant électronique d'un circuit électronique formé dans la première portion de substrat, du côté de la deuxième face du substrat ;
un premier moyen conducteur formé à travers la première portion et connectant électriquement une première borne du composant électronique à l'une des première et seconde électrodes, le premier moyen conducteur d'un ensemble de diodes électroluminescentes donné étant électriquement isolé des premiers moyens conducteurs des autres ensembles de diodes électroluminescentes.
Ce dispositif optoélectronique est tel que :
le substrat est composé d'au moins un matériau semiconducteur apte à servir de matériau de base à une formation d'au moins une partie du composant électronique d'un circuit électronique ;
ladite au moins une partie dudit composant électronique est formée à partir du matériau semiconducteur du substrat dans la première portion de substrat, du côté de la deuxième face du substrat.

Certains aspects préférés mais non limitatifs de ce dispositif optoélectronique sont les suivants.

La deuxième face du substrat est une surface libre.

Le substrat délimite un caisson au niveau de chaque première portion de substrat, la conductivité du caisson étant opposée à celle du substrat, le caisson étant ménagé dans la deuxième face du substrat et le composant électronique d'un circuit électronique étant formé dans le caisson de sorte à être en contact direct avec le substrat.

Ladite au moins une partie dudit composant électronique est une partie active.

Chaque composant électronique comprend une deuxième borne distincte et isolée de la première borne et le dispositif optoélectronique comprend un deuxième moyen conducteur connectant les deuxièmes bornes des composants électroniques de la pluralité d'ensemble de diodes électroluminescentes à l'autre des première et seconde électrodes.

Le deuxième moyen conducteur comprend un élément conducteur traversant le substrat en s'étendant de la première face à la deuxième face en dehors des premières portions associées à tous les ensembles de diodes électroluminescentes et une couche conductrice agencée du côté de la deuxième face.

L'élément conducteur est relié électriquement à la seconde électrode supérieure des ensembles de diodes électroluminescentes si le premier moyen conducteur de chaque ensemble de diodes électroluminescentes est en contact avec la première électrode inférieure dudit ensemble de diodes électroluminescentes, ou à la première électrode inférieure des ensembles de diodes électroluminescentes si le premier moyen conducteur de chaque ensemble de diodes électroluminescentes est en contact avec la seconde électrode supérieure dudit ensemble de diodes électrolu m inescentes.

Le dispositif optoélectronique comprend un circuit optoélectronique comportant des circuits électroniques élémentaires distincts reliés entre eux, où chaque circuit électronique élémentaire comprend d'une part l'un des ensembles de diodes électroluminescentes et d'autre part un circuit électronique de contrôle assurant le contrôle des diodes électroluminescentes de cet ensemble de diodes électroluminescentes, ce circuit électronique de contrôle étant agencé du côté de la deuxième face du substrat et le composant électronique de cet ensemble de diodes électroluminescentes faisant partie intégrante dudit circuit électronique de contrôle.

Le circuit électronique de contrôle des diodes électroluminescentes d'un ensemble de diodes électroluminescentes est configuré de sorte à remplir au moins l'une des fonctions suivantes : une commande de l'alimentation desdites diodes électroluminescentes, une protection desdites diodes électroluminescentes contre les décharges électrostatiques, une mémoire, une détection de la température desdites diodes électroluminescentes.

Le composant électronique est compris dans le groupe comprenant une diode, une diode Zener, une diode à avalanche, un transistor bipolaire, un transistor à effet de champ à grille métal-oxyde-semiconducteur, une résistance, une capacité métal-oxyde-semiconducteur, une capacité métal-isolant-métal, un thyristor, un varactor, une mémoire volatile et une mémoire non volatile.

La couche d'électrode conductrice supérieure qui recouvre au moins une partie des diodes électroluminescentes pour prendre un contact est formée dans un matériau au moins partiellement transparent à la lumière émise par les diodes électroluminescentes qu'il recouvre.

Au niveau de chaque ensemble de diodes électroluminescentes, la seconde électrode supérieure comprend une couche conductrice recouvrant au moins une partie de la couche d'électrode conductrice supérieure et agencée autour des diodes électroluminescentes.

Les éléments semiconducteurs des diodes électroluminescentes de chaque ensemble présentent une forme filaire, conique ou tronconique.

Au niveau de chaque ensemble de diodes électroluminescentes, la première portion du substrat constitue la première électrode inférieure et le premier mo_{y}en conducteur, la première face du substrat étant en contact avec les premières portions dopées de toutes les diodes électroluminescentes de cet ensemble et le composant électronique étant en contact avec le substrat au niveau de sa deuxième face de sorte que la connexion électrique entre la première borne du composant électronique et les premières portions dopées de toutes les diodes électroluminescentes de cet ensemble est assurée par la première portion.

Le premier moyen conducteur d'un ensemble de diodes électroluminescentes donné qui relie l'une des première et seconde électrodes à la première borne du composant électronique de cet ensemble est électriquement isolé du substrat et comprend un via électriquement conducteur s'étendant de la deuxième face jusqu'à la première face du substrat et électriquement connecté à l'électrode à laquelle le premier moyen conducteur est connecté.

Pour chaque ensemble de diodes électroluminescentes, la première électrode inférieure comprend au moins une couche d'électrode conductrice inférieure formée sur la première face du substrat et en contact avec les premières portions dopées de toutes les diodes électroluminescentes de cet ensemble.

L'invention porte également sur un procédé de fabrication d'un dispositif optoélectronique comprenant les étapes suivantes :
(a) prévoir un substrat monolithique délimitant une première face et une deuxième face opposées l'une par rapport à l'autre suivant l'épaisseur du substrat ;
(b) former une pluralité d'ensembles de diodes électroluminescentes où les diodes électroluminescentes d'un ensemble donné sont associées électriquement entre elles, étape (b) durant laquelle la formation de chaque ensemble de diodes électroluminescentes comprend la formation d'une pluralité de diodes électroluminescentes, du côté de la première face du substrat, sur une première portion correspondante du substrat, la formation de chaque diode électroluminescente comprenant une étape de formation d'éléments semiconducteurs dont une première portion dopée, une partie active et une seconde portion dopée ;
(c) former, pour chaque ensemble de diodes électroluminescentes, une première électrode inférieure en contact avec les premières portions dopées de toutes les diodes électroluminescentes de cet ensemble ;
(d) former, pour chaque ensemble de diodes électroluminescentes, une seconde électrode supérieure en contact avec les secondes portions dopées de toutes les diodes électroluminescentes de cet ensemble, la seconde électrode supérieure étant électriquement isolée par rapport à la première électrode inférieure et comprenant une étape de formation d'une couche d'électrode conductrice supérieure recouvrant au moins une partie de chaque diode électroluminescente de cet ensemble pour prendre un contact avec chaque diode électroluminescente ;
(e) former un composant électronique d'un circuit électronique dans la première portion de substrat, du côté de la deuxième face du substrat ;
(f) fournir un premier moyen conducteur formé à travers la première portion et apte à connecter électriquement une première borne du composant électronique formé à l'étape (e) à la première électrode inférieure formée à l'étape (c) ou à la seconde électrode supérieure formée à l'étape (d), l'étape (f) étant réalisée de sorte que le premier moyen conducteur d'un ensemble de diodes électroluminescentes donné soit électriquement isolé des premiers moyens conducteurs des autres ensembles de diodes électroluminescentes ;
le substrat étant composé d'au moins un matériau semiconducteur apte à servir de matériau de base à une formation d'au moins une partie du composant électronique, le procédé comportant une sous-étape (e1) de l'étape (e) consistant à la formation de ladite au moins une partie dudit composant électronique à partir du matériau semiconducteur du substrat dans la première portion de substrat, du côté de la deuxième face du substrat.

Certains aspects préférés mais non limitatifs de ce procédé de fabrication sont les suivants.

L'étape (f) est réalisée au moins en partie avant l'étape (b).

L'étape (f) est réalisée au moins en partie après l'étape (c) et après l'étape (d).

L'étape (e) est réalisée au moins en partie après l'étape (b).

L'étape (e) est réalisée au moins en partie après l'étape (c) et après l'étape (d).

L'étape (a) comprend une étape (h) consistant à réduire l'épaisseur du substrat du côté opposé à la première face , le substrat comprenant, après l'étape (h), la deuxième face opposée à la première face et l'étape (h) est réalisée avant l'étape (e).

Le procédé comprend une étape (i) consistant à former au moins un convertisseur de couleur recouvrant la deuxième électrode supérieure d'au moins un ensemble de diodes électroluminescentes et l'étape (e) est réalisée au moins en partie après l'étape (i).

Le procédé comprend une étape (g) consistant à former une couche d'encapsulation recouvrant la deuxième électrode et l'étape (e) est réalisée au moins en partie après l'étape (g).

L'étape (e) est réalisée à une température inférieure à 650°C.

Ladite au moins une partie dudit composant électronique est une partie active.

La deuxième face est une surface libre au moment de l'étape (e).

L'invention sera encore mieux comprise à l'aide de la description qui suit de modes particuliers de réalisation de l'invention donnés à titre d'exemples non limitatifs et représentés sur les dessins annexés, dans lesquels :
Les figures 1 et 2 sont des vues partielles, respectivement en coupe et de dessous, d'un premier mode de réalisation d'un dispositif optoélectronique selon l'invention.
Les figures 3 et 4 sont des vues partielles, respectivement en coupe et de dessus avant la formation des secondes électrodes supérieures, d'un deuxième mode de réalisation d'un dispositif optoélectronique selon l'invention.
La figure 5 illustre une variante de la figure 4.
Les figures 6 et 7 sont des vues partielles, respectivement en coupe et de dessus, d'un troisième mode de réalisation d'un dispositif optoélectronique selon l'invention.
La figure 8 représente, en coupe partielle, un premier exemple d'aménagement du composant électronique utilisé dans les deuxième et troisième modes de réalisation.
La figure 9 représente, en coupe partielle, un second exemple d'aménagement du composant électronique utilisé dans le premier mode de réalisation.
La figure 10 est un organigramme schématisant un exemple de circuit optoélectronique.

Sur les figures et dans la suite de la description, les mêmes références représentent les éléments identiques ou similaires. De plus, les différents éléments ne sont pas représentés à l'échelle de manière à privilégier la clarté des figures.

L'invention concerne, selon un premier aspect, un dispositif optoélectronique 10 comprenant un substrat 11 délimitant une première face 12 et une deuxième face 13 opposées l'une par rapport à l'autre suivant l'épaisseur E du substrat 11. L'invention concerne, selon un autre aspect, un procédé de fabrication d'un tel dispositif optoélectronique 10.

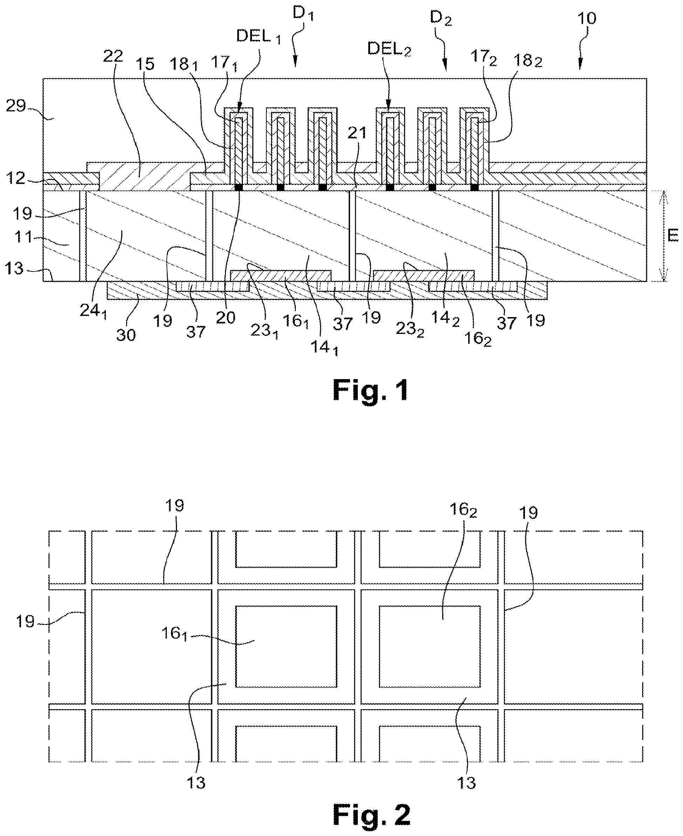

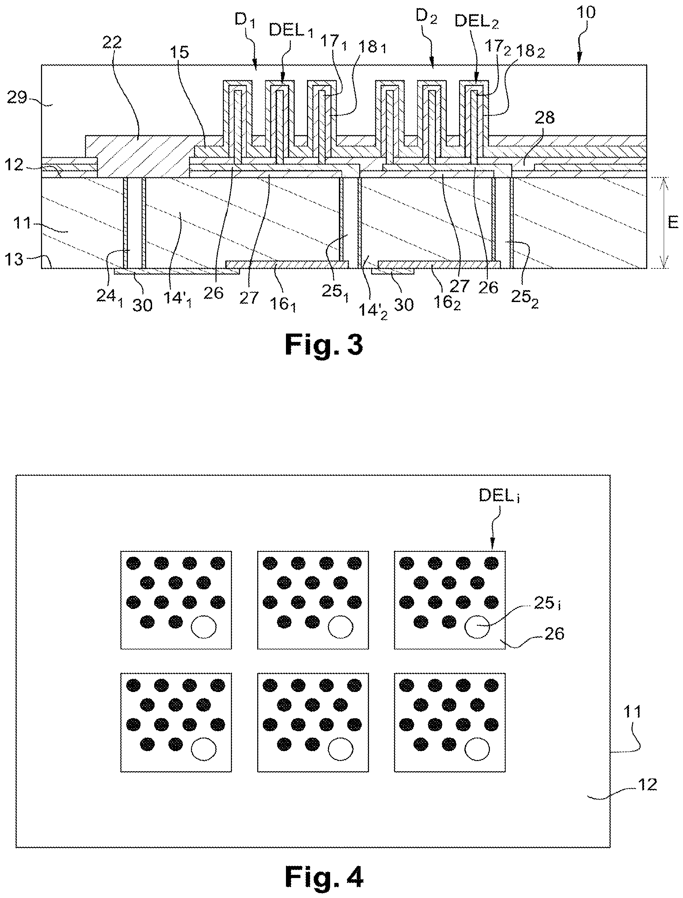

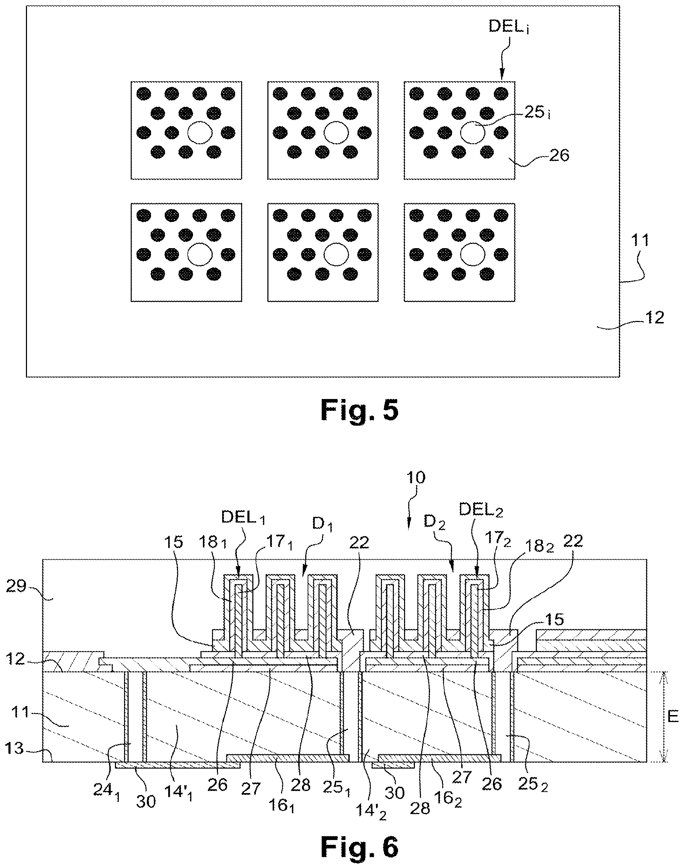

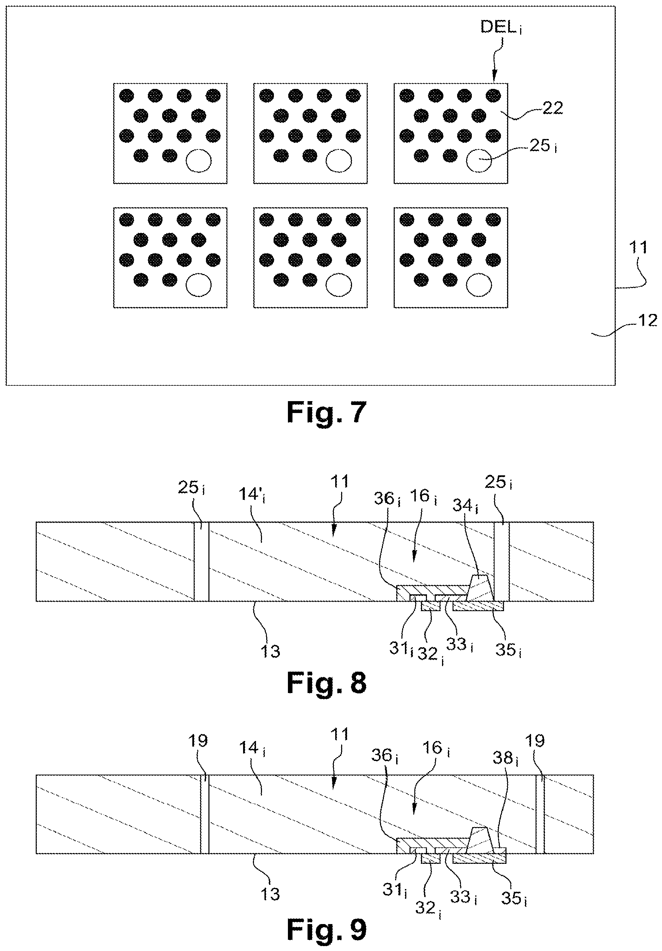

Les figures 1 et 2 font référence à un premier mode de réalisation de dispositif optoélectronique 10. Les figures 3 à 5 concernent un deuxième mode de réalisation de dispositif optoélectronique 10 et les figures 6 et 7 représentent un troisième mode de réalisation de dispositif optoélectronique 10. Ces différents modes de réalisation vont être détaillés ci-après. De même, les différentes étapes du procédé de fabrication seront expliquées en détails plus loin, de même que différentes variantes de mise en oeuvre du procédé de fabrication.

Les modes de réalisation décrits par la suite concernent des dispositifs optoélectroniques dont une application particulièrement visée est la fourniture d'un écran d'affichage d'images ou d'un dispositif de projection d'images.

En référence au premier mode de réalisation de la figure 1, le substrat 11 peut être au moins partiellement formé dans un matériau conducteur ou semiconducteur fortement dopé de sorte à avoir de bonnes propriétés de conductivité électrique, par exemple constitué en silicium de préférence monocristallin. Il peut aussi être formé en saphir voire en un matériau semiconducteur III-V, par exemple en GaN. Il peut alternativement s'agir d'un substrat de type silicium sur isolant ou « SOI » pour «Silicon On Insulator » selon la terminologie anglo-saxonne consacrée. Alternativement, comme cela sera expliqué plus loin, en référence aux deuxième et troisième modes de réalisation des figures 3 et 6 respectivement, le substrat 11 peut être formé dans un matériau semiconducteur ou électriquement isolant. Dans un exemple, illustré sur les figures 1, 3, 6, 8, 9, le substrat 11 est monolithique c'est-à-dire qu'il est formé d'un seul bloc et n'est pas formé d'un assemblage de plusieurs substrats différents connectés électriquement entre eux par un matériau conducteur.

La deuxième face 13 du substrat 11 est préférentiellement une surface libre comme illustré sur les figures 1,3 ,6, 8 et 9. En d'autres termes, la deuxième face 13, avant la formation d'un caisson 23ᵢ ou d'une partie du composant électronique d'un circuit électronique 16ᵢ n'est pas en contact direct avec une couche la recouvrant. Dans un exemple, le substrat 11 peut être composé naturellement d'une couche d'oxyde formée en son sein depuis sa surface externe, par exemple la deuxième face 13, suite au contact avec l'air ambiant. Cette même couche d'oxyde peut être formée de façon intentionnelle pour protéger ou isoler le substrat 11. Cette couche d'oxyde étant formée à partir des éléments atomiques du substrat 11, il faut comprendre que dans les termes « la deuxième face 13, avant la formation d'un caisson 23ᵢ ou d'une partie du composant électronique d'un circuit électronique 16ᵢ n'est pas en contact direct avec une couche la recouvrant », la couche d'oxyde formée à la surface du substrat fait partie du substrat 11 et donc que cette couche d'oxyde n'est pas comprise en tant que couche recouvrant par contact direct le substrat 11. Il en est de même pour toute couche formée à partir d'éléments atomiques compris dans le substrat, par exemple du SiC dans un substrat en silicium.

Dans tous les modes de réalisation représentés, le dispositif optoélectronique 10 comprend une pluralité d'ensembles Dᵢ de diodes électroluminescentes DELᵢ où les diodes électroluminescentes DELᵢ d'un ensemble Dᵢ donné sont associées électriquement entre elles. L'indice i associé à chaque ensemble de diodes électroluminescentes est un nombre entier compris entre 1 et n où n est le nombre total d'ensembles de diodes électroluminescentes. Chaque ensemble Dᵢ est notamment destiné à constituer un sous-pixel et comprend à cet effet une pluralité de diodes électroluminescentes DELᵢ agencées, du côté de la première face 12 du substrat 11, sur une première portion correspondante du substrat 11. Chaque pixel du dispositif optoélectronique 10 est constitué par la réunion d'au moins trois sous-pixels aptes à émettre directement, ou indirectement par l'intermédiaire d'au moins deux convertisseurs de lumière différents, trois lumières à des longueurs d'ondes différentes, par exemple des lumières respectivement bleue, verte et rouge. La première portion notée 14ᵢ correspond à chaque première portion du substrat 11 où sont formées les diodes électroluminescentes dans le cas particulier où le substrat 11 est électriquement conducteur. La première portion notée 14'ᵢ correspond à chaque première portion du substrat 11 où sont formées les diodes électroluminescentes dans le cas particulier où le substrat 11 est semiconducteur ou électriquement isolant.

Le nombre de diodes électroluminescentes DELᵢ que comprend chacun des ensembles Dᵢ peut varier en fonction par exemple de la dimension des diodes électroluminescentes ou de la résolution recherchée pour la pixellisation. Ce nombre peut être différent d'un ensemble à l'autre, et est par exemple compris entre 1 et 1000. La surface occupée par chaque sous-pixel en vue de dessus ou de dessous peut varier de 1 micron par 1 micron à plusieurs mm² et typiquement de 5 à 100 µm².

A des fins d'illustration exclusivement, mais sans aucune limitation, chacune des figures 1, 3 et 6 représente uniquement un premier ensemble D₁ comprenant trois diodes électroluminescentes DEL₁ et un deuxième ensemble D₂ comprenant trois diodes électroluminescentes DEL₂. Seuls deux ensembles D₁ et D₂ étant présents sur ces figures, ces dernières n'illustrent schématiquement que la présence de deux premières portions 14₁, 14₂ dans le premier mode de réalisation de la figure 1 ou 14'₁, 14'₂ dans les modes de réalisation des figures 3 et 6, dont le nombre total est en réalité égal au nombre d'ensemble Dᵢ.

Chaque diode électroluminescente DELᵢ comprend des éléments semiconducteurs dont une première portion dopée, une partie active et une seconde portion dopée. Les éléments semiconducteurs peuvent être agencés selon une organisation bidimensionnelle (non représentée) ou, comme cela est représenté, de manière tridimensionnelle, selon des dimensions micrométriques ou nanométriques. Préférentiellement, les éléments semiconducteurs des diodes électroluminescentes DELᵢ de chaque ensemble Dᵢ présentent une forme filaire, conique ou tronconique.

Dans la suite de la description et sur les figures, les modes de réalisation sont décrits pour des diodes électroluminescentes DELᵢ tridimensionnelles de type coeur-coquille. Toutefois, ces modes de réalisation peuvent indifféremment être mis en oeuvre pour des diodes électroluminescentes DELᵢ tridimensionnelles présentant une structure axiale où la première portion dopée, la partie active et la deuxième portion dopée sont empilées selon une direction transversale au plan du substrat 11.

De manière générale, chaque ensemble Dᵢ de diodes électroluminescentes DELᵢ comprend aussi une première électrode inférieure en contact avec les premières portions dopées de toutes les diodes électroluminescentes DELᵢ de cet ensemble Dᵢ et une seconde électrode supérieure en contact avec les secondes portions dopées de toutes les diodes électroluminescentes DELᵢ de cet ensemble Dᵢ.

La seconde électrode supérieure est électriquement isolée par rapport à la première électrode inférieure et comprend une couche d'électrode conductrice supérieure 15 recouvrant au moins une partie de chaque diode électroluminescente DELᵢ de l'ensemble Dᵢ concerné pour prendre un contact avec une diode électroluminescente DELᵢ.

Comme cela est représenté, chaque diode électroluminescente DELᵢ comprend un fil 17ᵢ formant la première portion dopée 17ᵢ, qu'elle soit de type N ou de type P, s'étendant transversalement au plan de la première face 12, et une coque 18ᵢ recouvrant au moins la partie supérieure du fil 17ᵢ. La coque 18ᵢ peut comprendre un empilement de plusieurs couches de matériaux semiconducteurs, notamment au moins une couche active recouvrant au moins la partie supérieure du fil 17ᵢ, une couche intermédiaire formant la seconde portion dopée et recouvrant la couche active, et éventuellement une couche de liaison recouvrant la couche intermédiaire et elle-même recouverte par la couche d'électrode conductrice supérieure 15.

A titre d'exemple, les fils 17ᵢ peuvent être, au moins en partie, formés à partir de matériaux semiconducteurs comportant majoritairement un composé III-V, par exemple des composés III-N. Des exemples du groupe III comprennent le gallium, l'indium ou l'aluminium. Des exemples de composés III-N sont GaN, AIN, InGaN ou AlInGaN. D'autres éléments du groupe V peuvent également être utilisés, par exemple, le phosphore, l'arsenic ou l'antimoine. De façon générale, les éléments dans le composé III-V peuvent être combinés avec différentes fractions molaires. Il convient de préciser que les fils 17ᵢ peuvent indifféremment être formés à partir de matériaux semiconducteurs comportant majoritairement un composé II-VI. Le dopant peut être choisi, dans le cas d'un composé III-V, parmi le groupe comprenant un dopant de type P du groupe II, par exemple du magnésium, du zinc, du cadmium ou du mercure, un dopant du type P du groupe IV par exemple du carbone, ou un dopant de type N du groupe IV, par exemple du silicium, du germanium, du sélénium, du souffre, du terbium ou de l'étain.

La section droite des fils 17ᵢ peut avoir différentes formes telles que, par exemple, une forme ovale, circulaire ou polygonale (par exemple carrée, rectangulaire, triangulaire, hexagonale).

La couche active est la couche depuis laquelle est émise la majorité du rayonnement fourni par la diode électroluminescente DELᵢ. Elle peut comporter des moyens de confinement des porteurs de charge électrique, tels que des puits quantiques. Elle est, par exemple, constituée d'une alternance de couches de GaN et d'InGaN. Les couches de GaN peuvent être dopées. Alternativement, la couche active est constituée par une unique couche d'InGaN.

La couche intermédiaire, dopée de type P si les fils 17ᵢ sont dopés de type N ou dopée de type N si les fils 17ᵢ sont dopés de type P, peut correspondre à une couche semi-conductrice ou à un empilement de couches semi-conductrices permettant la formation d'une jonction P-N ou P-I-N.

La couche de liaison peut correspondre à une couche semi-conductrice ou à un empilement de couches semi-conductrices et permet la formation d'un contact ohmique entre la couche intermédiaire et la seconde électrode.

De manière générale, chaque ensemble Dᵢ de diodes électroluminescentes DELᵢ comprend également un composant électronique d'un circuit électronique 16ᵢ décrit plus loin formé dans la première portion 14ᵢ, 14'ᵢ de substrat 11, du côté de la deuxième face 13 du substrat 11, et un premier moyen conducteur formé à travers la première portion 14ᵢ, 14'ᵢ de substrat 11 depuis la deuxième face 13 jusqu'à au moins la première face 12 et connectant électriquement une première borne du composant électronique à la première électrode ou à la seconde électrode.

Par « formé dans la première portion 14ᵢ, 14'ᵢ de substrat 11 », et comme illustré sur les figures 1, 3, 6, 8 et 9, il convient de comprendre « formé dans la première partie 14ᵢ, 14'ᵢ de substrat 11 en modifiant au moins en partie l'état électrique du substrat, par exemple en le rendant plus conducteur ou bien, par exemple dans le cas où le substrat 11 est dopé, en modifiant son dopage en un type de dopage différent ou bien en modifiant la concentration en dopants ».

Il est pris soin de garantir que le premier moyen conducteur d'un ensemble Dᵢ de diodes électroluminescentes DELᵢ donné soit électriquement isolé des premiers moyens conducteurs des autres ensembles Dᵢ de diodes électroluminescentes DELᵢ.

L'aménagement des composants électroniques du côté de la deuxième face 13, c'est-à-dire du côté opposé à la face sur laquelle sont aménagées les diodes électroluminescentes DELᵢ du dispositif optoélectronique 10, permet de ne pas perdre de place du côté de la première face 12, garantissant une grande densité de pixellisation et une excellente résolution en cas de nécessité.

Les composants électroniques sont directement obtenus sur le substrat 11 portant les diodes électroluminescentes DELᵢ, s'affranchissant de recours aux techniques d'hybridation de l'art antérieur, permettant de baisser les coûts et de simplifier considérablement la fabrication du dispositif optoélectronique 10.

Les modes de réalisation des différentes figures 1 à 7 diffèrent les uns des autres notamment dans la manière de constituer, pour chaque ensemble Dᵢ de diodes électroluminescentes DELᵢ, la première électrode inférieure et le premier moyen conducteur.

Dans le mode de réalisation des figures 1 et 2, le substrat 11 est tel qu'au niveau de chaque ensemble Dᵢ de diodes électroluminescentes DELᵢ, la première portion 14ᵢ du substrat 11, électriquement conductrice, constitue à la fois la première électrode inférieure et le moyen conducteur. La première face 12 du substrat 11 est en contact avec les premières portions dopées de toutes les diodes électroluminescentes DELᵢ de cet ensemble Dᵢ et le composant électronique est en contact avec le substrat 11 au niveau de sa deuxième face 13 de sorte que la connexion électrique entre la première borne du composant électronique et les premières portions dopées de toutes les diodes électroluminescentes DELᵢ de cet ensemble Dᵢ est assurée par la première portion 14;.

Pour cela, il est notamment prévu que le substrat 11 soit conducteur ou semiconducteur fortement dopé de façon à baisser la résistivité électrique jusqu'à une résistivité proche de celle des métaux, de préférence inférieure à quelques mohm.cm. Le substrat 11 peut être un substrat semiconducteur fortement dopé avec une concentration de dopants comprise entre 5^{∗}10¹⁶ atomes/cm³ et 2^{∗}10¹⁰ atomes/cm³ sans que cela ne soit limitatif, typiquement entre 1^{∗}10¹⁹ atomes/cm³ et 2^{∗}10¹⁰ atomes/cm³. Au début du procédé de fabrication du dispositif optoélectronique 10, le substrat 11 peut avoir une épaisseur comprise entre, par exemple, 275 microns et 1500 microns. Une fois que le dispositif optoélectronique 10 est réalisé, après une étape (h) d'amincissement décrite plus en détails par la suite, le substrat 11 présente une épaisseur notée « E » comprise entre 1 et 100 microns par exemple. Dans le cas d'un substrat 11 en silicium, des exemples de dopants de type P sont le bore ou l'indium tandis que des exemples de dopants de type N sont le phosphore, l'arsenic ou l'antimoine.

Dans le mode de réalisation des figures 1 et 2, le substrat 11 intègre dans son épaisseur E des éléments d'isolation électrique 19 s'étendant de la première face 12 à la deuxième face 13 du substrat 11 et délimitant deux à deux les premières portions 14ᵢ du substrat 11 associées aux ensembles Dᵢ de diodes électroluminescentes DELᵢ. Les premières portions 14ᵢ de substrat 11 sont électriquement isolées les unes des autres grâce aux éléments d'isolation électrique 19 de sorte à éviter, en pratique, les contacts électriques entre les premières électrodes inférieures de différents ensembles Dᵢ de diodes électroluminescentes DELᵢ.

Les éléments d'isolation électrique 19 peuvent comprendre des tranchées s'étendant chacune sur toute l'épaisseur E du substrat 11 et remplie d'un matériau électriquement isolant, par exemple un oxyde, notamment de l'oxyde de silicium, ou un polymère isolant. A titre de variante, les parois de chaque tranchée sont recouvertes d'une couche isolante, le reste de la tranchée étant remplie d'un matériau semiconducteur ou conducteur, par exemple du silicium polycristallin. Selon une autre variante, les éléments d'isolation électrique 19 comprennent des régions dopées d'un type de polarité opposé au substrat 11. A titre d'exemple, chaque tranchée a une largeur supérieure à 1 micron. Deux tranchées adjacentes délimitent entre elles la première portion 14ᵢ correspondante. Comme cela est visible sur la figure 2, les éléments d'isolation électrique 19 comprennent une première série de telles tranchées orientées selon une direction latérale du substrat 11 et ainsi échelonnées le long d'une direction longitudinale du substrat 11 et une seconde série de telles tranchées orientées selon la direction longitudinale du substrat 11 et donc échelonnées le long de la direction latérale du substrat 11. Cela permet de parvenir à une organisation matricielle des ensembles Dᵢ de diodes électroluminescentes DELᵢ dans le plan du substrat 11 et à une répartition identique, du côté de la deuxième face 13, de tous les composants électroniques associés aux différents ensembles Dᵢ de diodes électroluminescentes DELᵢ.

Il est précisé ici que de tels éléments d'isolation électrique 19 peuvent tout à fait être implémentés même dans le cas selon les deuxième et troisième modes de réalisation où le substrat 11 est formé dans un matériau semiconducteur ou électriquement isolant.

A titre d'exemple, chaque fil 17ᵢ peut être obtenu par croissance depuis un plot de nucléation 20 favorisant la croissance des fils 17ᵢ, chaque plot de nucléation 20 étant lui-même en contact avec la première face 12 du substrat 11 afin de garantir le rôle de première électrode inférieure à la première portion 14ᵢ correspondante du substrat 11. Un traitement peut être prévu pour protéger les flancs latéraux des plots de nucléation 20 et les zones de la première face 12 non recouvertes par les plots de nucléation 20 pour empêcher la croissance des fils 17ᵢ sur les flancs latéraux des plots de nucléation 20 et sur les zones de la première surface 12 non recouvertes par les plots de nucléation 20. Ce traitement peut comprendre la formation d'une couche isolante 21 sur les flancs latéraux des plots de nucléation 20 et, au niveau de chaque première portion 14ᵢ, sur les zones de la première face 12 non recouvertes par les plots de nucléation 20. Une manière de parvenir à ce résultat est de prévoir que la couche isolante 21 soit pourvue de trous aux emplacements destinés à être équipés de plots de nucléation 20, de former les plots de nucléation 20 dans ces trous délimités par la couche isolante 21, puis à réaliser la croissance des fils 17ᵢ à partir des plots de nucléation 20. Alternativement, les plots de nucléation 20 sont d'abord formés avant d'être recouverts par la couche isolante 21, puis des trous sont formés dans la couche isolante 21 au dessus des plots de nucléation 20 afin de pouvoir procéder ensuite à la croissance des fils 17ᵢ. La couche isolante 21 ainsi formée sur la première face 12 du substrat 11 au niveau des différentes premières portions 14ᵢ est également en mesure d'isoler électriquement, pour chaque ensemble Dᵢ de diodes électroluminescentes DELᵢ, la première électrode inférieure par rapport à la couche d'électrode conductrice supérieure 15 appartenant à la deuxième électrode supérieure.

A titre d'exemple, le matériau comportant les plots de nucléation 20 peut être un métal de transition de la colonne IV, V ou VI du tableau périodique des éléments ou un nitrure, un carbure ou un borure d'un métal de transition de la colonne IV, V ou VI, ou une combinaison de ces composés.

La couche isolante 21 peut être un matériau diélectrique, par exemple en oxyde de silicium, en nitrure de silicium, en oxynitrure de silicium, en oxyde d'aluminium, en oxyde d'hafnium, ou en diamant. Cette couche isolante 21 présente une épaisseur par exemple comprise entre 5 nm et 800 nm.

La couche d'électrode conductrice supérieure 15 qui recouvre au moins une partie des diodes électroluminescentes DELᵢ pour prendre un contact peut avantageusement être formée dans un matériau au moins partiellement transparent à la lumière émise par les diodes électroluminescentes DELᵢ qu'il recouvre. Le choix de ce matériau au niveau de chaque ensemble Dᵢ de diodes électroluminescentes DELᵢ peut tenir compte des longueurs d'ondes des lumières émises par les diodes électroluminescentes DELᵢ des différents ensembles Dᵢ.

La couche d'électrode conductrice supérieure 15 est, de manière générale, adaptée à polariser la couche active des diodes électroluminescentes DELᵢ et à laisser passer au moins une partie du rayonnement électromagnétique émis par les diodes électroluminescentes DELᵢ. Le matériau de cette couche 15 est, par exemple, de l'oxyde d'indium-étain (ou « ITO », acronyme anglais pour « Indium Tin Oxide »), de l'oxyde de zinc dopé à l'aluminium, au gallium ou à l'indium, ou du graphène. A titre d'exemple, la couche d'électrode conductrice supérieure 15 présente une épaisseur comprise entre 5 nm et 200 nm.

De plus, au niveau de chaque ensemble Dᵢ de diodes électroluminescentes DELᵢ, la seconde électrode supérieure comprend préférentiellement une couche conductrice 22 recouvrant au moins une partie de la couche d'électrode conductrice supérieure 15 et agencée autour des diodes électroluminescentes DELᵢ de cet ensemble Dᵢ. Cette couche conductrice 22 correspond, de préférence, à une couche métallique, par exemple en aluminium, en cuivre, en or, en ruthénium ou en argent, ou à un empilement de couches métalliques, par exemple en titane-aluminium, en silicium-aluminium, en titane-nickel-argent, en cuivre ou en zinc. Une telle couche conductrice 22 uniquement présente entre les diodes électroluminescentes DELᵢ permet de réduire les pertes résistives lors de la circulation du courant. Elle a également un rôle de réflecteur pour renvoyer vers l'extérieur les rayons émis par les diodes électroluminescentes DELᵢ dans la direction du substrat 11.

Dans chacun des trois modes de réalisation des figures 1 à 7, chaque composant électronique comprend une deuxième borne distincte et isolée de sa première borne et le dispositif optoélectronique 10 comprend un deuxième moyen conducteur traversant le substrat 11 et connectant les deuxièmes bornes des composants électroniques de la pluralité d'ensemble Dᵢ de diodes électroluminescentes DELᵢ à l'autre des première et seconde électrodes, c'est-à-dire à l'électrode non connectée au premier moyen conducteur évoqué précédemment. Notamment, le deuxième moyen conducteur est au moins partiellement formé en dehors des premières portions 14ᵢ, 14'ᵢ du substrat 11 et sur la deuxième face 13 du substrat 11. Le deuxième moyen conducteur peut notamment comprendre un élément conducteur 24ᵢ formé en dehors des premières portions 14ᵢ associées à tous les ensembles Dᵢ de diodes électroluminescentes DELᵢ, s'étendant de la première face 12 à la deuxième face 13 du substrat 11. L'élément conducteur 24ᵢ est relié électriquement soit à la seconde électrode supérieure des ensembles Dᵢ de diodes électroluminescentes DELᵢ si le premier moyen conducteur de chaque ensemble Dᵢ de diodes électroluminescentes DELᵢ est en contact avec la première électrode inférieure dudit ensemble Dᵢ de diodes électroluminescentes DELᵢ, soit à la première électrode inférieure des ensembles Dᵢ de diodes électroluminescentes DELᵢ si le premier moyen conducteur de chaque ensemble Dᵢ de diodes électroluminescentes DELᵢ est en contact avec la seconde électrode supérieure dudit ensemble Dᵢ de diodes électroluminescentes (DELᵢ).

La présence de cet élément conducteur 24ᵢ est avantageuse pour permettre de relier, via une couche conductrice 30 idoine agencée du côté de la deuxième face 13 du substrat 11, les deuxièmes bornes des composants électroniques entre elles. D'autre part, dans le cas d'un aménagement de plusieurs éléments conducteurs 24ᵢ où chacun est en contact avec la seconde électrode supérieure d'un ou plusieurs ensembles Dᵢ de diodes électroluminescentes DELᵢ, il est possible de raccorder, via la couche conductrice 30, ces secondes électrodes supérieures entre elles grâce à une connectique agencée du côté de la deuxième face 13 du substrat 11 et reliant les éléments conducteurs 24ᵢ entre eux. Cela permet avantageusement de s'affranchir de la nécessité de fabriquer une seconde électrode supérieure commune à toutes les diodes électroluminescentes DELᵢ du dispositif optoélectronique 10. Par exemple dans l'hypothèse de diodes électroluminescentes DELᵢ de forme plane, alors il devient possible d'éviter de devoir toutes les recouvrir avec une anode métallique opaque. Au contraire, il est possible de prévoir une anode en plusieurs parties respectivement agencées autour des diodes électroluminescentes DELᵢ planes et reliées entre elles par l'intermédiaire des éléments conducteurs 24ᵢ et de la couche conductrice 30 du côté de la deuxième face 13.

Il est donc compris que le deuxième moyen conducteur est constitué par la réunion d'au moins l'un des éléments conducteurs 24ᵢ et de la couche conductrice 30.

Dans le premier mode de réalisation des figures 1 et 2, chacun des éléments conducteurs 24ᵢ est formé par une portion du substrat 11 distincte des premières portions 14ᵢ sur lesquelles sont formées les diodes électroluminescentes DELᵢ et délimitée par les éléments d'isolation électrique 19 précédemment décrits. Les éléments conducteurs 24ᵢ du substrat 11 sont isolés électriquement entre eux et sont isolés par rapport aux différentes premières portions 14ᵢ de substrat 11 grâce à un aménagement idoine des tranchées constitutives des éléments d'isolation électrique 19. Dans ce premier mode de réalisation où la première électrode inférieure de chaque ensemble Dᵢ de diodes électroluminescentes DELᵢ est en contact avec le premier moyen conducteur de cet ensemble Dᵢ, tous deux étant constitués concrètement par la première portion 14ᵢ correspondante de cet ensemble Dᵢ comme cela a été expliqué précédemment, la seconde électrode supérieure de chaque ensemble Dᵢ de diodes électroluminescentes DELᵢ est reliée électriquement à un élément conducteur 24ᵢ correspondant. Plus précisément, les éléments conducteurs 24ᵢ sont en contact avec la couche conductrice 22 à travers un trou ménagé dans la couche isolante 21 et dans la couche d'électrode conductrice supérieure 15. Sur la figure 1, pour éviter un contact électrique par l'intermédiaire de la couche conductrice 30 entre l'élément conducteur 24ᵢ et les premières portions 14ᵢ qui sont conductrices, il est aménagé une couche électriquement isolante 37 organisée de manière idoine pour assurer une isolation électrique en complément des éléments d'isolation électrique 19.

A la différence du mode de réalisation des figures 1 et 2, les deux modes de réalisation suivants, respectivement en référence aux figures 3 à 5 et 6 à 7, sont tels que la première électrode inférieure et le premier moyen conducteur, pour chaque ensemble Dᵢ de diodes électroluminescentes DELᵢ, sont obtenus par des moyens autres que le substrat 11 lui-même. En effet, sur les figures 3 à 7, le premier moyen conducteur d'un ensemble Dᵢ de diodes électroluminescentes DELᵢ donné qui relie l'une des première et seconde électrodes à la première borne du composant électronique de cet ensemble Dᵢ est électriquement isolé du substrat 11 et comprend un via 25ᵢ électriquement conducteur s'étendant de la deuxième face 13 jusqu'à la première face 12 du substrat 11 et électriquement connecté à l'électrode à laquelle le premier moyen conducteur est connecté.

Dans les deux modes de réalisation des figures 3 à 7, contrairement au mode de réalisation des figures 1 et 2, le substrat 11 peut avantageusement être formé dans un matériau isolant ou dans un matériau semiconducteur faiblement dopé, ce qui présente comme avantage de faciliter considérablement la formation du composant électronique dans le cas où ce dernier comprend un transistor, notamment pour la fabrication d'un transistor avec un canal de conduction en son sein. En effet, la fabrication d'un tel transistor serait très délicate avec un substrat 11 conducteur ou semiconducteur fortement dopé comme c'est le cas dans le premier mode de réalisation des figures 1 et 2.

A la différence avec le premier mode de réalisation des figures 1 et 2 où les diodes électroluminescentes DELᵢ sont en contact électrique directement avec le substrat 11, chacun des deux modes de réalisation des figures 3 à 7 prévoit que la première électrode inférieure comprenne, pour chaque ensemble Dᵢ de diodes électroluminescentes DELᵢ, au moins une couche d'électrode conductrice inférieure 26 formée directement ou indirectement sur la première face 12 du substrat 11 et en contact avec les premières portions dopées de toutes les diodes électroluminescentes DELᵢ de cet ensemble Dᵢ.

La couche d'électrode conductrice inférieure 26 n'est pas continue et, au contraire, présente un motif garantissant l'isolation les unes par rapport aux autres des premières électrodes inférieures des différents ensembles Dᵢ de diodes électroluminescentes DELᵢ et de permettre la connexion électrique des électrodes aux premières bornes des composants électroniques 16ᵢ par l'intermédiaire des vias 25ᵢ.

Comme cela est représenté sur les figures 3 et 6, une couche électriquement isolante 27 peut être interposée entre le substrat 11 et la couche d'électrode conductrice inférieure 26. La couche électriquement isolante 27 présente notamment un motif pour les mêmes raisons que la couche d'électrode conductrice inférieure 26. La couche électriquement isolante 27 est formée sur la première face 12 du substrat 11 et la couche d'électrode conductrice inférieure 26 est elle-même formée sur la couche électriquement isolante 27.

Chaque via 25ᵢ est par exemple obtenu par l'aménagement d'un passage traversant formé sur toute l'épaisseur E du substrat 11 et débouchant sur ses deux faces 12, 13. Puis ce passage est rempli d'un matériau électriquement conducteur adapté, comme par exemple en silicium polycristallin fortement dopé. Les parois du passage peuvent éventuellement être au préalable tapissées par un matériau isolant, comme par exemple un oxyde de silicium, afin d'isoler électriquement le via 25ᵢ par rapport au substrat 11 qu'il traverse. Il est alternativement possible de créer des vias 25ᵢ par implantation ionique rendant le substrat 11 localement conducteur électriquement.

Préférentiellement, au niveau de chaque ensemble Dᵢ de diodes électroluminescentes DELᵢ, la couche d'électrode conductrice inférieure 26 comprend une couche de nucléation ou un empilement de couches de nucléation formées dans un matériau adapté à la croissance, sur ledit matériau, des éléments semiconducteurs des diodes électroluminescentes DELᵢ.

A titre d'exemple, le matériau composant la couche de nucléation peut être un nitrure, un carbure ou un borure d'un métal de transition de la colonne IV, V ou VI du tableau périodique des éléments ou une combinaison de ces composés. A titre d'exemple, la couche de nucléation peut être en nitrure d'aluminium, en oxyde d'aluminium, en bore, en nitrure de bore, en titane, en nitrure de titane, en tantale, en nitrure de tantale, en hafnium, en nitrure d'hafnium, en niobium, en nitrure de niobium, en zirconium, en borure de zirconium, en nitrure de zirconium, en carbure de silicium, en nitrure et carbure de tantale, ou en nitrure de magnésium sous la forme MgₓN_{y}, où x est environ égal à 3 et y est environ égal à 2, par exemple du nitrure de magnésium sous la forme Mg₃N₂. La couche de nucléation peut être dopée du même type de conductivité que celle des éléments semiconducteurs destinés à croître, et présenter une épaisseur par exemple comprise entre 1 nm et 200 nm, de préférence comprise entre 10 nm et 50 nm. La couche de nucléation peut être composée d'un alliage ou d'un empilement d'un ou de plusieurs matériaux mentionnés dans la liste ci-dessus.

Le dispositif optoélectronique 10 comporte en outre, dans chacun des modes de réalisation des figures 3 et 6, une couche d'isolation 28 formée sur la couche d'électrode conductrice inférieure 26 et interposée entre la couche d'électrode conductrice inférieure 26 et la couche d'électrode conductrice supérieure 15 afin d'isoler entre elles la première électrode inférieure et la seconde électrode supérieure.

La couche d'isolation 28 peut comprendre une première couche isolante intermédiaire qui recouvre ladite au moins une couche de nucléation. Elle forme un masque de croissance autorisant la croissance épitaxiale des premières portions dopées des diodes DELᵢ à partir d'ouvertures traversantes débouchant localement sur les surfaces de nucléation. Elle participe également à assurer l'isolation électrique entre les premières électrodes inférieures et les secondes électrodes supérieures. La première couche isolante intermédiaire est réalisée en un ou plusieurs matériau(x) diélectrique(s) tel(s) que, par exemple, un oxyde de silicium (par exemple SiO₂) ou un nitrure de silicium (par exemple Si₃N₄ ou SiN), voire un oxynitrure de silicium, un oxyde d'aluminium (par exemple Al₂O₃) ou un oxyde de hafnium (par exemple HfO₂). L'épaisseur de la première couche isolante intermédiaire peut être comprise entre 5 nm et 1 µm, de préférence comprise entre 20 nm et 500 nm, par exemple égale à 100 nm environ.

La couche d'isolation 28 peut comporter, en outre, une deuxième couche isolante intermédiaire qui recouvre les premières électrodes inférieures et participe à assurer l'isolation électrique entre les premières électrodes inférieures et les secondes électrodes supérieures. Elle peut recouvrir également le masque de croissance formé par la première couche isolante intermédiaire. Elle peut venir au contact d'une partie inférieure des secondes portions dopées incluses dans les coques 18ᵢ. La deuxième couche isolante intermédiaire peut être réalisée en un matériau diélectrique identique ou différent de celui du masque de croissance, tel que, par exemple, un oxyde de silicium (par exemple SiO₂) ou un nitrure de silicium (par exemple Si₃N₄ ou SiN), voire un oxynitrure de silicium, un oxyde d'aluminium (par exemple Al₂O₃) ou un oxyde de hafnium (par exemple HfO₂). L'épaisseur de la deuxième couche isolante intermédiaire peut être comprise entre 5 nm et 1 µm, de préférence comprise entre 20 nm et 500 nm, par exemple égale à 100 nm environ.

En référence au deuxième mode de réalisation tel que représenté sur les figures 3 à 5, les secondes électrodes supérieures de tous les ensembles Dᵢ de diodes électroluminescentes DELᵢ sont reliées électriquement entre elles et en contact électrique avec l'un des éléments conducteurs 24ᵢ afin d'être reliés aux deuxièmes bornes des composants électroniques par l'intermédiaire des deuxièmes moyens conducteurs tandis que les premières électrodes inférieures de tous les ensembles D; de diodes électroluminescentes DELᵢ sont toutes isolées les unes des autres et respectivement en contact avec la première borne du composant électronique correspondant par l'intermédiaire du premier moyen conducteur (c'est-à-dire ici le via 25ᵢ) correspondant.

Dans le cas où les diodes sont de type coeur-coquille où le coeur est dopé n et où la coquille est dopée p, alors les ensembles Dᵢ de diodes électroluminescentes DELᵢ ont une anode commune reliée aux deuxièmes bornes des composants électroniques des circuits 16ᵢ et les cathodes individuelles des ensembles Dᵢ de diodes électroluminescentes DELᵢ sont reliées respectivement aux premières bornes des composants électroniques des circuits 16ᵢ. A l'inverse, dans le cas où les diodes sont de type coeur-coquille où le coeur est dopé p et où la coquille est dopée n, alors les ensembles Dᵢ de diodes électroluminescentes DELᵢ ont une cathode commune reliée aux deuxièmes bornes des composants électroniques des circuits 16ᵢ et les anodes individuelles des ensembles Dᵢ de diodes électroluminescentes DELᵢ sont reliées respectivement aux premières bornes des composants électroniques des circuits 16ᵢ.

Dans la configuration de la figure 3, chacun des éléments conducteurs 24ᵢ est formé par un via formé à travers le substrat 11 d'une manière identique aux vias 25ᵢ. Les éléments conducteurs 24ᵢ sont isolés électriquement entre eux et sont isolés par rapport aux différentes premières portions 14'ᵢ de substrat 11 et par rapport aux différents vias 25ᵢ. Dans ce deuxième mode de réalisation où la première électrode inférieure de chaque ensemble Dᵢ de diodes électroluminescentes DELᵢ est en contact avec le premier moyen conducteur (c'est-à-dire ici avec le via 25ᵢ correspondant) de cet ensemble Dᵢ, la seconde électrode supérieure de chaque ensemble Dᵢ de diodes électroluminescentes DELᵢ est reliée électriquement à un élément conducteur 24ᵢ correspondant. Plus précisément, les éléments conducteurs 24ᵢ sont en contact avec la couche conductrice 22 à travers un trou ménagé à travers toute l'épaisseur de l'empilement formé par la couche d'électrode conductrice supérieure 15, la couche d'isolation 28, la couche d'électrode conductrice inférieure 26 et la couche électriquement isolante 27, ce trou débouchant sur la première face 12 du substrat 11.

En opposition au deuxième mode de réalisation des figures 3 à 5, en référence au troisième mode de réalisation tel que représenté sur les figures 6 et 7, les premières électrodes inférieures de tous les ensembles Dᵢ de diodes électroluminescentes DELᵢ peuvent être reliées électriquement entre elles et en contact électrique avec l'un des éléments conducteurs 24ᵢ afin d'être reliées aux deuxièmes bornes des composants électroniques par l'intermédiaire des deuxièmes moyens conducteurs tandis que les secondes électrodes supérieures de tous les ensembles Dᵢ de diodes électroluminescentes DELᵢ sont toutes isolées les unes des autres et respectivement en contact avec la première borne du composant électronique correspondant par l'intermédiaire du premier moyen conducteur (c'est-à-dire ici le via 25ᵢ) correspondant.

Dans le cas où les diodes sont de type coeur-coquille où le coeur est dopé n et où la coquille est dopée p, alors les ensembles Dᵢ de diodes électroluminescentes DELᵢ ont une cathode commune reliée aux deuxièmes bornes des composants électroniques des circuits 16ᵢ et les anodes individuelles des ensembles Dᵢ de diodes électroluminescentes DELᵢ sont reliées respectivement aux premières bornes des composants électroniques des circuits 16ᵢ. A l'inverse, dans le cas où les diodes sont de type coeur-coquille où le coeur est dopé p et où la coquille est dopée n, alors les ensembles Dᵢ de diodes électroluminescentes DELᵢ ont une anode commune reliée aux deuxièmes bornes des composants électroniques des circuits 16ᵢ et les cathodes individuelles des ensembles Dᵢ de diodes électroluminescentes DELᵢ sont reliées respectivement aux premières bornes des composants électroniques des circuits 16ᵢ.

Dans la configuration de la figure 6, chacun des éléments conducteurs 24ᵢ est formé à travers le substrat 11 par un via formé de manière identique aux vias 24ᵢ. Les éléments conducteurs 24ᵢ du substrat 11 sont isolés électriquement entre eux et sont isolés par rapport aux différentes premières portions 14'ᵢ de substrat 11 et par rapport aux différents vias 25ᵢ. Dans ce troisième mode de réalisation où la seconde électrode supérieure de chaque ensemble Dᵢ de diodes électroluminescentes DELᵢ est en contact avec le premier moyen conducteur (c'est-à-dire ici avec le via 25ᵢ correspondant) de cet ensemble Dᵢ, la première électrode inférieure de chaque ensemble Dᵢ de diodes électroluminescentes DELᵢ est reliée électriquement à un élément conducteur 24ᵢ correspondant. Plus précisément, les éléments conducteurs 24ᵢ sont en contact avec la couche d'électrode conductrice inférieure 26 à travers un trou traversant l'épaisseur de la couche électriquement isolante 27, ce trou débouchant sur la première face 12 du substrat 11.

Les figures 4 et 7 montrent que, pour chaque ensemble Dᵢ de diodes électroluminescentes DELᵢ, le premier moyen conducteur (ici le via 25ᵢ) qui relie la première borne du composant électronique agencé du côté de la deuxième face 13 et l'une des première et seconde électrodes toutes deux agencées du côté de la première face 12 peut être disposé au coin de chaque sous-pixel. La figure 5 montre par contre que ce premier moyen conducteur (c'est-à-dire ici le via 25ᵢ) peut alternativement être agencé au centre de chaque sous-pixel. La particularité des figures 4 et 5, à des fins de meilleure compréhension, repose sur le fait qu'elles illustrent chacune la situation avant la formation des secondes électrodes supérieures, voire même avant la formation de la couche d'isolation 28. Au contraire, la figure 7 illustre la situation après la formation des secondes électrodes supérieures, celles-ci étant alors individuelles du fait que c'est la cathode (constituée par la première électrode inférieure) qui est commune aux différents ensembles Dᵢ de diodes électroluminescentes DELᵢ.

La figure 8 représente en détails, dans le cas particulier où le substrat 11 est semiconducteur ou isolant électriquement, une possibilité de réaliser la connexion entre le via 25ᵢ et le drain 33ᵢ d'un transistor constitutif du composant électronique agencé du côté de la face arrière 13, typiquement par la formation d'une connexion 35ᵢ, par exemple en siliciure tel que le siliciure de titane, le siliciure de cobalt, le siliciure de nickel, le siliciure de platine ou le siliciure de tungstène, connectant le via 25i au drain 33ᵢ. Ce transistor est très avantageusement inclus dans l'épaisseur E du substrat 11, du côté de la deuxième face 13 opposée à la première face 12 sur laquelle les diodes électroluminescentes DELᵢ sont agencées, en étant au moins partiellement, voire préférentiellement en intégralité, logé dans le caisson 23ᵢ formé dans le substrat 11 du côté de la deuxième face 13, ce caisson 23ᵢ débouchant vers l'extérieur du substrat 11 afin de faciliter l'exécution des étapes de formation du composant électronique. Le transistor peut également comprendre une grille 32ᵢ, une source 31ᵢ et un caisson d'isolation 36ᵢ et être connecté à d'autres éléments électroniques constituant l'électronique de contrôle. Le caisson d'isolation 36ᵢ est formé dans un matériau dopé entre 1^{∗}10¹⁶ atomes/cm³ et 3^{∗}10¹⁷ atomes/cm³. La source 31ᵢ et le drain 33ᵢ sont également dopés, typiquement entre 1^{∗}10¹⁸ atomes/cm³ et 2^{∗}10²⁰ atomes/cm³. Le drain 33ᵢ et le caisson d'isolation 36ᵢ dudit transistor peut être isolé du via 25ᵢ par une tranchée d'isolation 34ᵢ (couramment appelée « Shallow Trench Isolation » en terminologie anglo-saxonne ou STI). Dans ce cas, le siliciure recouvre le STI pour permettre une connexion électrique entre le drain 33ᵢ dudit transistor et le via 25ᵢ. La longueur de grille peut être déterminée en fonction du niveau de fuite acceptable. La largeur de grille peut être déterminée en fonction du courant acceptable. A titre d'exemple, la largeur de grille est inférieure à 1 micron pour faire circuler une intensité de 40 µA dans des sous-pixels présentant un pas de 30 microns. L'épaisseur de l'isolant destiné à encapsuler les circuits électroniques individuels du côté de la deuxième face 13 peut être déterminée en fonction d'une valeur admissible de champ.

Par contre, dans le cas particulier où le substrat 11 est électriquement conducteur, la figure 9 illustre la présence d'un élément de reprise de contact 38ᵢ entre la connexion 35ᵢ et le substrat 11.

Le dispositif optoélectronique 10 comporte préférentiellement une couche d'encapsulation 29 formée sur les secondes électrodes supérieures et enrobant toutes les diodes électroluminescentes DELᵢ du côté opposé au substrat 11 afin de les protéger. La couche d'encapsulation 29 est préférentiellement formée de sorte à recouvrir l'ensemble de la structure. Le matériau de la couche d'encapsulation 29 peut être transparent.

Le dispositif optoélectronique 10 peut éventuellement comporter un ou plusieurs convertisseur(s) de couleur non représenté(s), agencé(s) dans la couche d'encapsulation 29 ou sur celle-ci. Un convertisseur de couleur donné peut être positionné à la verticale d'un ensemble Dᵢ de diodes électroluminescentes DELᵢ afin de convertir la couleur de la lumière émise par les diodes électroluminescentes DELᵢ. A titre d'exemple, un ensemble Dᵢ de diodes électroluminescentes DELᵢ, constitutif d'un sous-pixel donné, comprend des diodes électroluminescentes DELᵢ aptes à émettre intrinsèquement une couleur bleue, le convertisseur de couleur associé à cet ensemble Dᵢ servant alors à convertir cette couleur bleue en une couleur rouge ou en une couleur verte destinée à être émise hors du dispositif optoélectronique 10 à travers la face supérieure opposée au substrat 11.

Le dispositif optoélectronique 10 comprend, de manière générale, un circuit optoélectronique 40 comportant des circuits électroniques élémentaires 40ᵢ distincts reliés entre eux, où chaque circuit électronique élémentaire 40ᵢ comprend :
- l'un des ensembles Dᵢ de diodes électroluminescentes DELᵢ,
- un circuit électronique 16ᵢ de contrôle assurant le contrôle des diodes électroluminescentes DELᵢ de cet ensemble de diodes électroluminescentes, ce circuit électronique 16ᵢ de contrôle étant agencé du côté de la deuxième face 13 du substrat 11 et le composant électronique de cet ensemble de diodes électroluminescentes faisant partie intégrante dudit circuit électronique 16ᵢ de contrôle.

Notamment, le circuit électronique 16ᵢ de contrôle des diodes électroluminescentes DELᵢ d'un ensemble Dᵢ de diodes électroluminescentes est configuré de sorte à remplir au moins l'une des fonctions suivantes : une commande de l'alimentation des diodes électroluminescentes de cet ensemble, une protection des diodes électroluminescentes de cet ensemble contre les décharges électrostatiques, une mémoire, une détection de la température des diodes électroluminescentes de cet ensemble. La nature et la conception de chaque circuit électronique 16ᵢ de contrôle n'apporte aucune limitation quant au champ d'application des principes décrits dans le présent document.

A titre d'exemple, le composant électronique est compris dans le groupe comprenant une diode, une diode Zener, une diode à avalanche, un transistor bipolaire, un transistor à effet de champ à grille métal-oxyde-semiconducteur, une résistance, une capacité métal-oxyde-semiconducteur, une capacité métal-isolant-métal, un thyristor, un varactor, une mémoire volatile et une mémoire non volatile.

Afin de réduire l'encombrement du dispositif optoélectronique 10 suivant son épaisseur E, le substrat 11 délimite préférentiellement, au niveau de chaque première portion 14ᵢ de substrat 11, un caisson 23ᵢ, dont la conductivité est opposée à celle du substrat 11, ménagé dans la deuxième face 13 et le composant électronique est formé dans ce caisson 23ᵢ de sorte à être en contact direct avec le substrat 11. Il est précisé que par « conductivité opposée » il est équivalent de comprendre que le caisson 23ᵢ a une conductivité modifiée par rapport à celle du substrat 11. Le composant électronique logé dans le caisson 23ᵢ est contenu au moins partiellement, voire préférentiellement en intégralité, dans l'épaisseur E du substrat 11. Dans un exemple, le caisson 23ᵢ est ménagé dans la deuxième face 13 du substrat 11, le composant électronique étant formé au moins en partie dans le caisson 23ᵢ de sorte à faire partie intégrante avec une partie du substrat 11.

Il est possible de prévoir que les composants électroniques soient des transistors en couches minces, connus dans le domaine concerné sous l'appellation « TFT » pour « Thin Film Transistor » selon la terminologie anglo-saxonne appropriée, ou de type « OTFT » pour « Organic Thin Film Transistor » selon la terminologie anglo-saxonne appropriée. Un avantage des transistors de type OTFT est de présenter des longueurs de grille sub-microniques compatibles avec l'agencement de très petits pixels avec des capacités parasites limitées pour pouvoir commuter à environ 10 MHz. Un autre avantage est qu'ils peuvent être fabriqués à très basse température, typiquement à environ 60°C. Un avantage supplémentaire est qu'il n'est pas nécessaire d'utiliser le substrat 11 comme support d'électronique.

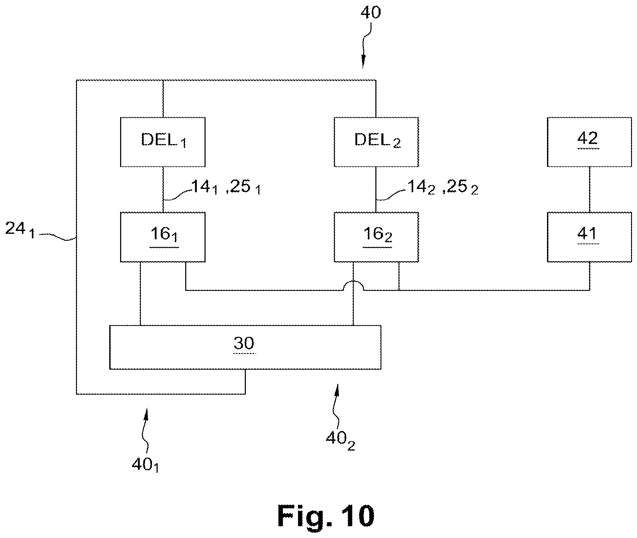

La figure 10 illustre schématiquement un exemple de circuit optoélectronique 40 afin de clarifier la compréhension générale pour le lecteur, dans le cas particulier à deux circuits électroniques élémentaires 40₁, 40₂ distincts reliés entre eux. Le circuit électronique élémentaire 40₁ comprend l'ensemble D₁ de diodes électroluminescentes DEL₁ et le circuit électronique 16₁ de contrôle assurant le contrôle des diodes électroluminescentes DEL₁ de cet ensemble D₁ de diodes électroluminescentes DEL₁. Le circuit électronique 16₁ de contrôle est agencé du côté de la deuxième face 13 du substrat 11 et le composant électronique de cet ensemble D₁ de diodes électroluminescentes DEL₁ fait partie intégrante du circuit électronique 16₁ de contrôle. Le circuit électronique élémentaire 40₂ comprend l'ensemble D₂ de diodes électroluminescentes DEL₂ et le circuit électronique 16₂ de contrôle assurant le contrôle des diodes électroluminescentes DEL₂ de cet ensemble D₂ de diodes électroluminescentes DEL₂. Le circuit électronique 16₂ de contrôle est agencé du côté de la deuxième face 13 du substrat 11 et le composant électronique de cet ensemble D₂ de diodes électroluminescentes DEL₂ fait partie intégrante du circuit électronique 16₂ de contrôle. Le premier moyen conducteur associé à l'ensemble D₁ (correspondant par exemple à la première portion 14₁ dans le cas où le substrat 11 est conducteur ou au via 25₁ dans le cas où le substrat 11 est semiconducteur ou électriquement isolant) qui est formé à travers la première portion 14₁, 14'₁ assure la connexion électrique de l'une des première et seconde électrodes des diodes DEL₁ à la première borne du composant électronique du circuit électronique 16₁. Le deuxième moyen conducteur constitué de la combinaison de l'élément conducteur 24₁ et de la couche conductrice 30 connecte l'autre des première et seconde électrodes des diodes DEL₁ à la deuxième borne du composant électronique du circuit électronique 16₁. Le premier moyen conducteur associé à l'ensemble D₂ (correspondant par exemple à la première portion 14₂ dans le cas où le substrat 11 est conducteur ou au via 25₂ dans le cas où le substrat 11 est semiconducteur ou électriquement isolant) qui est formé à travers la première portion 14₂, 14'₂ assure la connexion électrique de l'une des première et seconde électrodes des diodes DEL₂ à la première borne du composant électronique du circuit électronique 16₂. Le deuxième moyen conducteur constitué de la combinaison de l'élément conducteur 24₁ et de la couche conductrice 30 connecte l'autre des première et seconde électrodes des diodes DEL₂ à la deuxième borne du composant électronique du circuit électronique 16₂. Les deuxièmes bornes des composants électroniques des circuits électroniques 16₁, 16₂ sont connectées entre elles via le deuxième moyen conducteur. Les circuits électroniques 16₁, 16₂ sont reliées à une unité de pilotage 41 et à une source d'alimentation 42.

Un mode de réalisation d'un procédé de fabrication du dispositif optoélectronique 10 peut comprendre les étapes suivantes, non forcément successives :
(a) prévoir le substrat 11 délimitant la première face 12 et une deuxième face 13 opposées l'une par rapport à l'autre suivant l'épaisseur E du substrat 11;
(b) former la pluralité d'ensembles Dᵢ de diodes électroluminescentes DELᵢ où les diodes électroluminescentes DELᵢ d'un ensemble Dᵢ donné sont associées électriquement entre elles, étape (b) durant laquelle la formation de chaque ensemble Dᵢ de diodes électroluminescentes DELᵢ comprend la formation d'une pluralité de diodes électroluminescentes DELᵢ, du côté de la première face 12 du substrat 11, sur la première portion 14ᵢ, 14'ᵢ correspondante du substrat 11, la formation de chaque diode électroluminescente DELᵢ comprenant une étape de formation d'éléments semiconducteurs dont une première portion dopée, une partie active et une seconde portion dopée ;
(c) former, pour chaque ensemble Dᵢ de diodes électroluminescentes DELᵢ, une première électrode inférieure en contact avec les premières portions dopées de toutes les diodes électroluminescentes DELᵢ de cet ensemble Dᵢ ;
(d) former, pour chaque ensemble Dᵢ de diodes électroluminescentes DELᵢ, une seconde électrode supérieure en contact avec les secondes portions dopées de toutes les diodes électroluminescentes DELᵢ de cet ensemble Dᵢ, la seconde électrode supérieure étant électriquement isolée par rapport à la première électrode inférieure et comprenant une étape de formation de la couche d'électrode conductrice supérieure 15 recouvrant au moins une partie de chaque diode électroluminescente DELᵢ de cet ensemble Dᵢ pour prendre un contact avec chaque diode électroluminescente DELᵢ ;
(e) former le composant électronique du circuit électronique 16ᵢ dans la première portion 14ᵢ, 14'ᵢ de substrat 11, du côté de la deuxième face 13 du substrat 11 ;
(f) fournir le premier moyen conducteur formé à travers la première portion 14ᵢ, 14'ᵢ et qui permet de connecter électriquement la première borne du composant électronique formé à l'étape (e) à la première électrode inférieure formée à l'étape (c) ou à la seconde électrode supérieure formée à l'étape (d), l'étape (f) étant réalisée de sorte que le premier moyen conducteur d'un ensemble Dᵢ de diodes électroluminescentes DELᵢ donné soit électriquement isolé des premiers moyens conducteurs des autres ensembles Dᵢ de diodes électroluminescentes DELᵢ.

Comme il ressort des explications précédentes, l'étape (f) peut consister, dans le premier mode de réalisation des figures 1 et 2, en la combinaison d'une étape (a) où le substrat 11 est conducteur ou semiconducteur fortement dopé, d'une étape (b) où les premières portions dopées des diodes électroluminescentes DELᵢ sont formées sur la première face 12 du substrat 11 et de la mise en oeuvre d'une étape de formation des éléments d'isolation électrique 19 délimitant entre eux, deux à deux, les premières portions 14ᵢ, 14'ᵢ du substrat 11.

L'étape de formation des éléments d'isolation électrique 19 peut notamment comprendre une étape de gravure, pour chaque élément d'isolation électrique 19, d'une ouverture (par exemple sous la forme d'une tranchée telle que précédemment décrite) dans le substrat 11. L'ouverture peut être formée par toute technique connue, par exemple par une gravure ionique réactive. La profondeur de l'ouverture est strictement supérieure à l'épaisseur E visée du substrat 11 après une étape (h) d'amincissement décrite par la suite. L'étape de formation des éléments d'isolation électrique 19 peut ensuite comprendre une étape de remplissage de l'ouverture précédemment gravée avec un matériau de remplissage électriquement isolant, par exemple un oxyde, notamment de l'oxyde de silicium, ou un polymère isolant. En variante, il est possible de prévoir de recouvrir uniquement les parois de chaque ouverture gravée avec une couche isolante, le reste de la tranchée étant ensuite remplie d'un matériau semiconducteur ou conducteur, par exemple du silicium polycristallin.

D'ailleurs, il est possible d'aboutir à la formation des secondes portions 24ᵢ grâce à la formation des éléments d'isolation électrique 19 telle que décrite ci-avant.

Alternativement, comme il ressort des explications précédentes, l'étape (f) peut consister, dans le deuxième mode de réalisation des figures 3 à 5, en la combinaison de l'étape (c), d'une étape (b) où les premières portions dopées des diodes électroluminescentes DELᵢ sont formées de sorte à être en contact avec la première électrode inférieure formée à l'étape (c), et de la formation des vias 25ᵢ en contact avec la première électrode inférieure formée à l'étape (c).

En variante, comme il ressort des explications précédentes, l'étape (f) peut consister, dans le troisième mode de réalisation des figures 6 et 7, en la combinaison de l'étape (d), d'une étape (b) où les secondes portions dopées des diodes électroluminescentes DELᵢ sont formées de sorte à être en contact avec la seconde électrode supérieure formée à l'étape (d), et de la formation des vias 25ᵢ en contact avec la seconde électrode supérieure formée à l'étape (d).

L'étape de formation des vias 25ᵢ peut être réalisée selon toute technique connue de l'Homme du Métier. A titre d'exemple, l'étape de formation des vias 25ᵢ comprend, pour chaque via 25ᵢ, une étape de formation d'un passage traversant formé dans le substrat 11. Ce passage peut être formé par toute technique connue. La profondeur du passage est strictement supérieure à l'épaisseur E visée du substrat 11 après l'étape (h) d'amincissement. L'étape de formation des vias 25ᵢ peut ensuite comprendre une étape de remplissage du passage avec un matériau électriquement conducteur adapté, comme par exemple du silicium polycristallin fortement dopé. En variante, il est possible de prévoir de recouvrir au préalable les parois du passage avec un matériau isolant, comme par exemple un oxyde de silicium, afin d'isoler électriquement le via 25ᵢ par rapport au substrat 11 qu'il traverse.

Pour la mise en oeuvre l'étape (f), l'étape de formation des vias 25ᵢ ou l'étape de formation des éléments d'isolation électrique 19 peut soit être réalisée au moins en partie avant l'étape (b), soit être réalisée au moins en partie après l'étape (c) et après l'étape (d).

Préférentiellement, l'étape (e) est réalisée au moins en partie après l'étape (b), notamment en raison de la contrainte thermique liée à la croissance des éléments semiconducteurs des diodes électroluminescentes DELᵢ.

Préférentiellement, l'étape (e) est réalisée au moins en partie après l'étape (c) et après l'étape (d), afin d'éviter que les étapes de formation des première et secondes électrodes ne détériorent un composant électronique précédemment formé.

Comme il l'a été précédemment indiqué, l'étape (a) peut éventuellement comprendre une étape (h) consistant à réduire l'épaisseur du substrat 11 du côté opposé à la première face 12, le substrat 11 délimitant, après cette étape (h), la deuxième face 13 opposée à la première face 12. Autrement dit, c'est après l'étape (h) que le substrat 11 présente l'épaisseur E. L'étape (h) peut être réalisée selon toute technique connue, par des procédés mécaniques et/ou chimiques éventuellement suivis d'un polissage. Préférentiellement, l'étape (h) est réalisée avant l'étape (e).

L'étape (e) peut comprendre une étape de formation du caisson 23ᵢ dans la deuxième face 13 puis une étape de formation du composant électronique dans le caisson 23ᵢ ainsi précédemment formé.

Le procédé peut comprendre une étape (i) consistant à former au moins un convertisseur de couleur recouvrant la deuxième électrode supérieure d'au moins un ensemble Dᵢ de diodes électroluminescentes DELᵢ. L'étape (i) peut être réalisée au moins en partie avant l'étape (h), permettant un collage du substrat au-dessus du CCM permanent. Alternativement, l'étape (i) peut être réalisée au moins en partie après l'étape (h) afin de pouvoir augmenter le budget thermique.

Préférentiellement, l'étape consistant à former le composant électronique dans la première portion 14ᵢ, 14'ᵢ de substrat 11, du côté de la deuxième face 13 du substrat 11, est réalisée au moins en partie après l'étape (i), afin d'éviter que la formation des convertisseurs de couleur ne détériore un composant électronique précédemment formé.

L'étape (g) facultative consistant à former la couche d'encapsulation 29 qui recouvre la deuxième électrode supérieure est préférentiellement réalisée au moins en partie avant l'étape (e).

Dans l'exemple préférentiel où le substrat 11 est monolithique et composé d'au moins un matériau semiconducteur apte à servir de matériau de base à une formation d'au moins une partie du composant électronique d'un circuit électronique 16i, le procédé comporte avantageusement une sous-étape (e1) de l'étape (e) consistant à la formation de ladite au moins une partie dudit composant électronique d'un circuit électronique 16ᵢ à partir du matériau semiconducteur du substrat 11 dans la première portion 14ᵢ, 14'ᵢ de substrat 11, du côté de la deuxième face 13 du substrat 11.

Dans un exemple, ladite au moins une partie dudit composant électronique d'un circuit électronique 16i est une partie active.

Dans un exemple de procédé, la deuxième face 13 est une surface libre au moment de l'étape (e).

Les composants électroniques peuvent être formés par des procédés dits « froids », c'est-à-dire que l'étape (e) est réalisée à une température inférieure à 650°C. Typiquement, les opérations nécessaires à l'étape (e) peuvent être réalisées à une température comprise entre 250°C et 650°C, typiquement d'environ 450°C, permettant de ne pas endommager les parties actives des diodes électroluminescentes DELᵢ précédemment formés à l'étape (b). Les composants électroniques peuvent être formés par des procédés empruntés aux techniques des CMOS (pour « Complementary Métal Oxide Semiconductor » selon la terminologie appropriée) monolithiques ou bien aux techniques des TFT, ou hybrides. Les composants électroniques peuvent également être de type OTFT de sorte que les opérations nécessaires à l'étape (e) puissent être réalisées à une température quasi-ambiante, typiquement de l'ordre de 60°C.

## Revendications

1. Dispositif optoélectronique (10) comprenant un substrat (11) monolithique délimitant une première face (12) et une deuxième face (13) opposées l'une par rapport à l'autre suivant l'épaisseur (E) du substrat (11), et une pluralité d'ensembles (Dᵢ) de diodes électroluminescentes (DELᵢ) où les diodes électroluminescentes (DELᵢ) d'un ensemble (Dᵢ) donné sont associées électriquement entre elles
dans lequel chaque ensemble (Dᵢ) de diodes électroluminescentes (DELᵢ) comprend :
une pluralité de diodes électroluminescentes (DELᵢ) agencées, du côté de la première face (12) du substrat (11), sur une première portion (14ᵢ, 14'ᵢ) correspondante du substrat (11), chaque diode électroluminescente (DELᵢ) comprenant des éléments semiconducteurs dont une première portion dopée, une partie active et une seconde portion dopée ;
une première électrode inférieure en contact avec les premières portions dopées de toutes les diodes électroluminescentes (DELᵢ) de l'ensemble (Dᵢ) ;
une seconde électrode supérieure en contact avec les secondes portions dopées de toutes les diodes électroluminescentes (DELᵢ) de l'ensemble (Dᵢ), la seconde électrode supérieure étant électriquement isolée par rapport à la première électrode inférieure et comprenant une couche d'électrode conductrice supérieure (15) recouvrant au moins une partie de chaque diode électroluminescente (DELᵢ) dudit ensemble (Dᵢ) pour prendre un contact avec chaque diode (DELᵢ) ;
un composant électronique d'un circuit électronique (16ᵢ) formé dans la première portion (14ᵢ, 14'ᵢ) de substrat (11), du côté de la deuxième face (13) du substrat (11) ;
un premier moyen conducteur formé à travers la première portion (14ᵢ, 14'ᵢ) et connectant électriquement une première borne du composant électronique à l'une des première et seconde électrodes, le premier moyen conducteur d'un ensemble (Dᵢ) de diodes électroluminescentes (DELᵢ) donné étant électriquement isolé des premiers moyens conducteurs des autres ensembles (Dᵢ) de diodes électroluminescentes (DELᵢ) ;
dans lequel le substrat (11) est composé d'au moins un matériau semiconducteur apte à servir de matériau de base à une formation d'au moins une partie du composant électronique et
dans lequel ladite au moins une partie dudit composant électronique est formée à partir du matériau semiconducteur du substrat (11) dans la première portion (14ᵢ, 14'ᵢ) de substrat (11), du côté de la deuxième face (13) du substrat (11).

2. Dispositif optoélectronique (10) selon la revendication 1, **caractérisé en ce que** le substrat (11) délimite un caisson (23ᵢ) au niveau de chaque première portion (14ᵢ, 14'ᵢ) de substrat (11), le caisson (23ᵢ) ayant une conductivité opposée à celle du substrat (11) et étant ménagé dans la deuxième face (13) du substrat (11), le composant électronique étant formé au moins en partie dans le caisson (23ᵢ) de sorte à être en contact direct avec le substrat (11).

3. Dispositif optoélectronique (10) selon l'une des revendications 1 ou 2, **caractérisé en ce que** ladite au moins une partie dudit composant électronique est une partie active.

4. Dispositif optoélectronique (10) selon l'une des revendications 1 à 3, **caractérisé en ce que** chaque composant électronique comprend une deuxième borne distincte et isolée de la première borne et **en ce que** le dispositif optoélectronique (10) comprend un deuxième moyen conducteur (24ᵢ, 30) connectant les deuxièmes bornes des composants électroniques de la pluralité d'ensemble (Dᵢ) de diodes électroluminescentes (DELᵢ) à l'autre des première et seconde électrodes.

5. Dispositif optoélectronique (10) selon la revendication 4, **caractérisé en ce que** le deuxième moyen conducteur (24ᵢ, 30) comprend un élément conducteur (24ᵢ) traversant le substrat (11) en s'étendant de la première face (12) à la deuxième face (13) en dehors des premières portions (14ᵢ, 14'ᵢ) associées à tous les ensembles (Dᵢ) de diodes électroluminescentes (DELᵢ) et une couche conductrice (30) agencée du côté de la deuxième face (13).

6. Dispositif optoélectronique selon l'une quelconque des revendications 1 à 5, **caractérisé en ce que** le dispositif optoélectronique (10) comprend un circuit optoélectronique (40) comportant des circuits électroniques élémentaires (40ᵢ) distincts reliés entre eux, où chaque circuit électronique élémentaire (40ᵢ) comprend d'une part l'un des ensembles (Dᵢ) de diodes électroluminescentes (DELᵢ) et d'autre part un circuit électronique (16ᵢ) de contrôle assurant le contrôle des diodes électroluminescentes (DELᵢ) de cet ensemble (Dᵢ) de diodes électroluminescentes (DELi), ce circuit électronique (16ᵢ) de contrôle étant agencé du côté de la deuxième face (13) du substrat (11) et le composant électronique de cet ensemble (Dᵢ) de diodes électroluminescentes (DELᵢ) faisant partie intégrante dudit circuit électronique (16ᵢ) de contrôle.

7. Dispositif optoélectronique (10) selon l'une quelconque des revendications 1 à 6, **caractérisé en ce que** les éléments semiconducteurs des diodes électroluminescentes (DELᵢ) de chaque ensemble (Dᵢ) présentent une forme filaire, conique ou tronconique.

8. Dispositif optoélectronique (10) selon l'une des revendications 1 à 7, **caractérisé en ce qu'**au niveau de chaque ensemble (Dᵢ) de diodes électroluminescentes (DELᵢ), la première portion (14ᵢ) du substrat (11) constitue la première électrode inférieure et le premier moyen conducteur, la première face (12) du substrat (11) étant en contact avec les premières portions dopées de toutes les diodes électroluminescentes (DELᵢ) de cet ensemble (Dᵢ) et le composant électronique étant en contact avec le substrat (11) au niveau de sa deuxième face (13) de sorte que la connexion électrique entre la première borne du composant électronique et les premières portions dopées de toutes les diodes électroluminescentes (DELᵢ) de cet ensemble (Dᵢ) est assurée par la première portion (14ᵢ).

9. Dispositif optoélectronique (10) selon l'une des revendications 1 à 7, **caractérisé en ce que** le premier moyen conducteur d'un ensemble (Dᵢ) de diodes électroluminescentes (DELᵢ) donné qui relie l'une des première et seconde électrodes à la première borne du composant électronique de cet ensemble (Dᵢ) est électriquement isolé du substrat (11) et comprend un via (25ᵢ) électriquement conducteur s'étendant de la deuxième face (13) jusqu'à la première face (12) du substrat (11) et électriquement connecté à l'électrode à laquelle le premier moyen conducteur est connecté.

10. Dispositif optoélectronique (10) selon l'une des revendication 1 à 9, **caractérisé en ce que** pour chaque ensemble (Dᵢ) de diodes électroluminescentes (DELᵢ), la première électrode inférieure comprend au moins une couche d'électrode conductrice inférieure (26) formée sur la première face (12) du substrat (11) et en contact avec les premières portions dopées de toutes les diodes électroluminescentes (DEL) de cet ensemble (Dᵢ).

11. Procédé de fabrication d'un dispositif optoélectronique (10) comprenant les étapes suivantes :
(a) prévoir un substrat (11) monolithique délimitant une première face (12) et une deuxième face (13) opposées l'une par rapport à l'autre suivant l'épaisseur (E) du substrat (11) ;
(b) former une pluralité d'ensembles (Dᵢ) de diodes électroluminescentes (DELᵢ) où les diodes électroluminescentes (DELᵢ) d'un ensemble (Dᵢ) donné sont associées électriquement entre elles, étape (b) durant laquelle la formation de chaque ensemble (Dᵢ) de diodes électroluminescentes (DELᵢ) comprend la formation d'une pluralité de diodes électroluminescentes (DELᵢ), du côté de la première face (12) du substrat (11), sur une première portion (14ᵢ, 14'ᵢ) correspondante du substrat (11), la formation de chaque diode électroluminescente (DELᵢ) comprenant une étape de formation d'éléments semiconducteurs dont une première portion dopée, une partie active et une seconde portion dopée ;
(c) former, pour chaque ensemble (Dᵢ) de diodes électroluminescentes (DELᵢ), une première électrode inférieure en contact avec les premières portions dopées de toutes les diodes électroluminescentes (DELᵢ) de cet ensemble (Dᵢ) ;
(d) former, pour chaque ensemble (Dᵢ) de diodes électroluminescentes (DELᵢ), une seconde électrode supérieure en contact avec les secondes portions dopées de toutes les diodes électroluminescentes (DELᵢ) de cet ensemble (Dᵢ), la seconde électrode supérieure étant électriquement isolée par rapport à la première électrode inférieure et comprenant une étape de formation d'une couche d'électrode conductrice supérieure (15) recouvrant au moins une partie de chaque diode électroluminescente (DELᵢ) de cet ensemble (Dᵢ) pour prendre un contact avec chaque diode électroluminescente (DELᵢ) ;
(e) former un composant électronique d'un circuit électronique (16ᵢ) dans la première portion (14ᵢ, 14'ᵢ) de substrat (11), du côté de la deuxième face (13) du substrat (11) ;
(f) fournir un premier moyen conducteur formé à travers la première portion (14ᵢ, 14'ᵢ) et apte à connecter électriquement une première borne du composant électronique formé à l'étape (e) à la première électrode inférieure formée à l'étape (c) ou à la seconde électrode supérieure formée à l'étape (d), l'étape (f) étant réalisée de sorte que le premier moyen conducteur d'un ensemble (Dᵢ) de diodes électroluminescentes (DELᵢ) donné soit électriquement isolé des premiers moyens conducteurs des autres ensembles (Dᵢ) de diodes électroluminescentes (DELᵢ) ; et
dans lequel le substrat (11) est composé d'au moins un matériau semiconducteur apte à servir de matériau de base à une formation d'au moins une partie du composant électronique, le procédé comportant une sous-étape (e1) de l'étape (e) consistant à la formation de ladite au moins une partie dudit composant électronique à partir du matériau semiconducteur du substrat (11) dans la première portion (14ᵢ, 14'ᵢ) de substrat (11), du côté de la deuxième face (13) du substrat (11).

12. Procédé selon la revendication 11, **caractérisé en ce que** ladite au moins une partie dudit composant électronique est une partie active.

13. Procédé selon l'une quelconque des revendications 11 ou 12, **caractérisé en ce que** l'étape (a) comprend une étape (h) consistant à réduire l'épaisseur du substrat (11) du côté opposé à la première face (12), le substrat (11) comprenant, après l'étape (h), la deuxième face (13) opposée à la première face (12) et **en ce que** l'étape (h) est réalisée avant l'étape (e).

14. Procédé selon l'une quelconque des revendications 11 à 13, **caractérisé en ce qu'**il comprend une étape (i) consistant à former au moins un convertisseur de couleur recouvrant la deuxième électrode supérieure d'au moins un ensemble (Dᵢ) de diodes électroluminescentes (DELᵢ) et **en ce que** l'étape (e) est réalisée au moins en partie après l'étape (i).

15. Procédé selon l'une quelconque des revendications 11 à 14, **caractérisé en ce que** la deuxième face (13) est une surface libre au moment de l'étape (e).

## Patentansprüche

1. Optoelektronische Vorrichtung (10), ein monolithisches Substrat (11) umfassend, das eine erste Fläche (12) und eine zweite Fläche (13) abgrenzt, die einander gegenüberliegen, der Dicke (E) des Substrats (11) folgend, und eine Vielzahl von Anordnungen (Dᵢ) von Leuchtdioden (DELi), wobei die Leuchtdioden (DELᵢ) einer gegebenen Anordnung (Dᵢ) elektrisch miteinander assoziiert sind, wobei jede Anordnung (Dᵢ) von Leuchtdioden (DELᵢ) umfasst:
eine Vielzahl von Leuchtdioden (DELi), die auf der Seite der ersten Fläche (12) des Substrats (11) auf einem entsprechenden ersten Abschnitt (14i, 14'i) des Substrats (11) angeordnet sind, wobei jede Leuchtdiode (DELᵢ) Halbleiterelemente umfasst, einschließlich eines ersten dotierten Abschnitts, eines aktiven Teilstücks und eines zweiten dotierten Abschnitts;
eine erste untere Elektrode in Kontakt mit den ersten dotierten Abschnitten aller Leuchtdioden (DELᵢ) der Anordnung (Dᵢ);
eine zweite obere Elektrode in Kontakt mit den zweiten dotierten Abschnitten aller Leuchtdioden (DELᵢ) der Anordnung (Dᵢ), wobei die zweite obere Elektrode elektrisch von der ersten unteren Elektrode isoliert ist und eine obere leitfähige Elektrodenschicht (15) umfasst, die mindestens ein Teilstück jeder Leuchtdiode (DELᵢ) der Anordnung bedeckt (Dᵢ), um einen Kontakt mit jeder Diode (DELᵢ) herzustellen;
ein elektronisches Bauelement einer elektronischen Schaltung (16i), das im ersten Abschnitt (14ᵢ, 14'ᵢ) des Substrats (11) auf der Seite der zweiten Fläche (13) des Substrats (11) gebildet ist;
ein erstes leitfähiges Mittel, das durch den ersten Abschnitt (14ᵢ, 14'ᵢ) hindurch gebildet wird, und eine erste Klemme des elektronischen Bauelements elektrisch mit einer der ersten und zweiten Elektroden verbindet, wobei das erste leitfähige Mittel einer gegebenen Anordnung (Dᵢ) von Leuchtdioden (DELᵢ) elektrisch von den ersten leitfähigen Mitteln der anderen Anordnungen (Dᵢ) von Leuchtdioden (DELᵢ) isoliert ist;
wobei das Substrat (11) aus mindestens einem Halbleitermaterial hergestellt ist, das geeignet ist, als Basismaterial für die Bildung mindestens eines Teilstück des elektronischen Bauelements zu dienen, und wobei das mindestens eine Teilstück des elektronischen Bauelements aus dem Halbleitermaterial des Substrats (11) im ersten Abschnitt (14ᵢ, 14'ᵢ) des Substrats (11) gebildet ist, auf der Seite der zweiten Fläche (13) des Substrats (11).

2. Optoelektronische Vorrichtung (10) nach Anspruch 1, **dadurch gekennzeichnet, dass** das Substrat (11) ein Gehäuse (23ᵢ) an jedem ersten Abschnitt (14ᵢ, 14'ᵢ) des Substrats (11) abgrenzt, wobei das Gehäuse (23ᵢ) eine Leitfähigkeit hat, die der des Substrats (11) entgegengesetzt ist und in der zweiten Fläche (13) des Substrats (11) vorgesehen ist, wobei das elektronische Bauelement mindestens teilweise im Gehäuse (23ᵢ) so ausgebildet ist, dass es in direktem Kontakt mit dem Substrat (11) steht.

3. Optoelektronische Vorrichtung (10) nach einem der Ansprüche 1 oder 2, **dadurch gekennzeichnet, dass** das mindestens eine Teilstück des elektronischen Bauelements ein aktives Teilstück ist.

4. Optoelektronische Vorrichtung (10) nach einem der Ansprüche 1 bis 3, **dadurch gekennzeichnet, dass** jedes elektronische Bauelement eine zweite Klemme umfasst, die separat und isoliert von der ersten Klemme ist, und dass die optoelektronische Vorrichtung (10) ein zweites leitfähiges Mittel (24ᵢ, 30) umfasst, das die zweiten Klemmen der elektronischen Bauelemente der Vielzahl der Anordnung (Dᵢ) von Leuchtdioden (DELᵢ) mit der anderen der ersten und zweiten Elektroden verbindet.

5. Optoelektronische Vorrichtung (10) nach Anspruch 4, **dadurch gekennzeichnet, dass** das zweite leitfähige Mittel (24ᵢ, 30) ein leitfähiges Element (24ᵢ) umfasst, das das Substrat (11) durchquert und sich von der ersten Fläche (12) zur zweiten Fläche (13) außerhalb der ersten Abschnitte (14ᵢ, 14'ᵢ) erstreckt, die mit allen Anordnungen (Dᵢ) von Leuchtdioden (DELᵢ) assoziiert sind, und eine leitfähige Schicht (30), die auf der Seite der zweiten Fläche (13) angeordnet ist.

6. Optoelektronische Vorrichtung nach einem der Ansprüche 1 bis 5, **dadurch gekennzeichnet, dass** die optoelektronische Vorrichtung (10) eine optoelektronische Schaltung (40) umfasst, die separate miteinander verbundene elementare elektronische Schaltungen (40ᵢ) beinhaltet, wobei jede elementare elektronische Schaltung (40ᵢ) einerseits eine Anordnung (Dᵢ) der Leuchtdioden (DELᵢ) umfasst und andererseits eine elektronische Steuerschaltung (16i), die die Steuerung der Leuchtdioden (DELᵢ) dieser Anordnung (Dᵢ) von Leuchtdioden (DELᵢ) gewährleistet, wobei diese elektronische Steuerschaltung (16ᵢ) auf der Seite der zweiten Fläche (13) des Substrats (11) angeordnet ist und das elektronische Bauelement dieser Anordnung (Dᵢ) von Leuchtdioden (DELᵢ) integraler Bestandteil der elektronischen Steuerschaltung (16) ist.

7. Optoelektronische Vorrichtung (10) nach einem der Ansprüche 1 bis 6, **dadurch gekennzeichnet, dass** die Halbleiterelemente der Leuchtdioden (DELᵢ) jeder Anordnung (Dᵢ) eine Draht-, Kegel oder Kegelstumpfform aufweisen.

8. Optoelektronische Vorrichtung (10) nach einem der Ansprüche 1 bis 7, **dadurch gekennzeichnet, dass** an jeder Anordnung (Dᵢ) von Leuchtdioden (DELᵢ) der erste Abschnitt (14ᵢ) des Substrats (11) die erste untere Elektrode und das erste leitfähige Mittel ausmacht, wobei die erste Fläche (12) des Substrats (11) mit den ersten dotierten Abschnitten aller Leuchtdioden (DELᵢ) dieser Anordnung (Dᵢ) in Kontakt steht und das elektronische Bauelement mit dem Substrat (11) an seiner zweiten Fläche (13) in Kontakt steht, so dass die elektrische Verbindung zwischen der ersten Klemme des elektronischen Bauelements und den ersten dotierten Abschnitten aller Leuchtdioden (DELᵢ) dieser Anordnung (Dᵢ) durch den ersten Abschnitt (14ᵢ) gewährleistet ist.

9. Optoelektronische Vorrichtung (10) nach einem der Ansprüche 1 bis 7, **dadurch gekennzeichnet, dass** das erste leitfähige Mittel einer gegebenen Anordnung (Dᵢ) von Leuchtdioden (DELᵢ), das eine der ersten und zweiten Elektroden mit der ersten Klemme des elektronischen Bauelements dieser Anordnung (Dᵢ) verbindet, elektrisch vom Substrat (11) isoliert ist und eine elektrisch leitfähige Via (25ᵢ) umfasst, die sich von der zweiten Fläche (13) bis zur ersten Fläche (12) des Substrats (11) erstreckt, und elektrisch mit der Elektrode verbunden ist, mit der das erste leitfähige Mittel verbunden ist.

10. Optoelektronische Vorrichtung (10) nach einem der Ansprüche 1 bis 9, **dadurch gekennzeichnet, dass** für jede Anordnung (Dᵢ) von Leuchtdioden (DELᵢ) die erste untere Elektrode mindestens eine untere leitfähige Elektrodenschicht (26) umfasst, die auf der ersten Fläche (12) des Substrats (11) gebildet ist und mit den ersten dotierten Abschnitten aller Leuchtdioden (DELᵢ) dieser Anordnung (Dᵢ) in Kontakt steht.

11. Herstellungsverfahren einer optoelektronischen Vorrichtung (10), das die folgenden Schritten umfasst:
(a) Vorsehen eines monolithischen Substrats (11), das eine erste Fläche (12) und eine zweite Fläche (13) abgrenzt, die einander gegenüberliegen, der Dicke (E) des Substrats (11) folgend;
(b) Bilden einer Vielzahl von Anordnungen (Dᵢ) von Leuchtdioden (DELᵢ), wobei die Leuchtdioden (DELᵢ) einer gegebenen Anordnung (Dᵢ) elektrisch miteinander assoziiert sind, wobei der Schritt (b), während dem die Bildung jeder Anordnung (Dᵢ) von Leuchtdioden (DELᵢ) die Bildung einer Vielzahl von Leuchtdioden (DELᵢ) auf der Seite der ersten Fläche (12) des Substrats (11) auf einem entsprechenden ersten Abschnitt (14ᵢ, 14'ᵢ) des Substrats (11) umfasst, der Bildung jeder Leuchtdiode (DELᵢ) einen Schritt zur Bildung von Halbleiterelementen umfasst, einschließlich eines ersten dotierten Abschnitts, eines aktiven Teilstücks und eines zweiten dotierten Abschnitts;
(c) Bilden, für jede Anordnung (Dᵢ) von Leuchtdioden (DELᵢ), einer ersten unteren Elektrode in Kontakt mit den ersten dotierten Abschnitten aller Leuchtdioden (DELᵢ) dieser Anordnung (Dᵢ);
(d) Bilden, für jede Anordnung (Dᵢ) von Leuchtdioden (DELᵢ), einer zweiten oberen Elektrode in Kontakt mit den zweiten dotierten Abschnitten aller Leuchtdioden (DELᵢ) dieser Anordnung (Dᵢ), wobei die zweite obere Elektrode elektrisch von der ersten unteren Elektrode isoliert ist und einen Schritt zur Bildung einer oberen leitfähigen Elektrodenschicht (15) umfasst, die mindestens ein Teilstück jeder Leuchtdiode (DELᵢ) dieser Anordnung (Dᵢ) bedeckt, um einen Kontakt mit jeder Leuchtdiode (DELᵢ) herzustellen;
(e) Bilden eines elektronischen Bauelements einer elektronischen Schaltung (16ᵢ) im ersten Abschnitt (14ᵢ, 14'ᵢ) des Substrats (11), auf der Seite der zweiten Fläche (13) des Substrats (11);
(f) Bereitstellen eines ersten leitfähigen Mittels, das durch den ersten Abschnitt (14ᵢ, 14'ᵢ) hindurch gebildet wird, und geeignet ist, eine erste Klemme des elektronischen Bauelements, die in Schritt (e) gebildet wurde, mit der ersten unteren Elektrode, die in Schritt (c) gebildet wurde, elektrisch zu verbinden oder mit der zweiten obere Elektrode, die in Schritt (d) gebildet wurde, wobei der Schritt (f) so ausgeführt wird, dass das erste leitfähige Mittel einer gegebenen Anordnung (Dᵢ) von Leuchtdioden (DELᵢ) elektrisch von den ersten leitfähigen Mitteln der anderen Anordnungen (Dᵢ) von Leuchtdioden (DELᵢ) isoliert ist; und
wobei das Substrat (11) aus mindestens einem Halbleitermaterial hergestellt ist, das geeignet ist, als Basismaterial für die Bildung mindestens eines Teilstücks des elektronischen Bauelements zu dienen, wobei das Verfahren einen Teilschritt (e1) des Schritts (e) beinhaltet, der darin besteht, das mindestens eine Teilstück des elektronischen Bauelements aus dem Halbleitermaterial des Substrats (11) im ersten Abschnitt (14ᵢ, 14'_{i.}) des Substrats (11) zu bilden, auf der Seite der zweiten Fläche (13) des Substrats (11).

12. Verfahren nach Anspruch 11, **dadurch gekennzeichnet, dass** das mindestens eine Teilstück des elektronischen Bauelements ein aktives Teilstück ist.

13. Verfahren nach einem der Ansprüche 11 oder 12, **dadurch gekennzeichnet, dass** der Schritt (a) einen Schritt (h) umfasst, der darin besteht, die Dicke des Substrats (11) auf der der ersten Fläche (12) gegenüberliegenden Seite zu verringern, wobei das Substrat (11), nach Schritt (h), die der ersten Fläche (12) gegenüberliegende zweite Fläche (13) umfasst, und dass der Schritt (h) vor dem Schritt (e) ausgeführt wird.

14. Verfahren nach einem der Ansprüche 11 bis 13, **dadurch gekennzeichnet, dass** es einen Schritt (i) umfasst, der darin besteht, mindestens einen Farbkonverter zu bilden, der die zweite obere Elektrode mindestens einer Anordnung (Dᵢ) von Leuchtdioden (DELᵢ) bedeckt, und dass der Schritt (e) mindestens teilweise nach dem Schritt (i) ausgeführt wird.

15. Verfahren nach einem der Ansprüche 11 bis 14, **dadurch gekennzeichnet, dass** die zweite Fläche (13) zum Zeitpunkt des Schrittes (e) eine freie Oberfläche ist.

## Claims

1. An optoelectronic device (10) comprising a monolithic substrate (11) delimiting a first face (12) and a second face (13) opposite to one another along the thickness (E) of the substrate (11), and a plurality of sets (Dᵢ) of light-emitting diodes (LEDᵢ) where the light-emitting diodes (LEDᵢ) of a given set (Dᵢ) are electrically associated together
in which each set (Dᵢ) of light-emitting diodes (LEDᵢ) comprises:
a plurality of light-emitting diodes (LEDᵢ) arranged, on the side of the first face (12) of the substrate (11), over a corresponding first portion (14ᵢ, 14'ᵢ) of the substrate (11), each light-emitting diode (LEDᵢ) comprising semiconductor elements including a first doped portion, an active portion and a second doped portion;
a first lower electrode in contact with the first doped portions of all of the light-emitting diodes (LEDᵢ) of the set (Dᵢ);
a second upper electrode in contact with the second doped portions of all of the light-emitting diodes (LEDᵢ) of the set (Dᵢ), the second upper electrode being electrically-insulated with respect to the first lower electrode and comprising an upper conductive electrode layer (15) covering at least one portion of each light-emitting diode (LEDᵢ) of said set (Dᵢ) so as to contact with each diode (LEDᵢ);
an electronic component of an electronic circuit (16ᵢ) formed in the first portion (14i, 14'ᵢ) of the substrate (11), on the side of the second face (13) of the substrate (11);
a first conductive means formed through the first portion (14ᵢ, 14'ᵢ) and electrically connecting a first terminal of the electronic component to one amongst the first and second electrodes, the first conductive means of a given set (Dᵢ) of light-emitting diodes (LEDᵢ) being electrically-insulated from the first conductive means of the other sets (Dᵢ) of light-emitting diodes (LEDᵢ);
in which the substrate (11) is composed by at least one semiconductor material adapted to serve as a base material for the formation of at least one portion of the electronic component and in which said at least one portion of said electronic component is formed from the semiconductor material of the substrate (11) in the first portion (14ᵢ, 14'ᵢ) of the substrate (11), on the side of the second face (13) of the substrate (11).

2. The optoelectronic device (10) according to claim 1, **characterized in that** the substrate (11) delimits a box (23ᵢ) at the level of each first portion (14ᵢ, 14'ᵢ) of the substrate (11), the box (23ᵢ) having a conductivity opposite to that of the substrate (11) and being formed in the second face (13) of the substrate (11), the electronic component being formed at least partially in the box (23ᵢ) so as to be in direct contact with the substrate (11).

3. The optoelectronic device (10) according to any of claims 1 or 2, **characterized in that** said at least one portion of said electronic component is an active portion.

4. The optoelectronic device (10) according to any of claims 1 to 3, **characterized in that** each electronic component comprises a second terminal distinct and insulated from the first terminal and **in that** the optoelectronic device (10) comprises a second conductive means (24ᵢ, 30) connecting the second terminals of the electronic components of the plurality of sets (Dᵢ) of light-emitting diodes (LEDᵢ) to the other one amongst the first and second electrodes.

5. The optoelectronic device (10) according to claim 4, **characterized in that** the second conductive means (24ᵢ, 30) comprises a conductive element (24ᵢ) crossing the substrate (11) by extending from the first face (12) to the second face (13) outside the first portions (14ᵢ, 14'ᵢ) associated to all of the sets (Dᵢ) of light-emitting diodes (LEDᵢ) and a conductive layer (30) arranged on the side of the second face (13).

6. The optoelectronic device according to any one of claims 1 to 5, **characterized in that** the optoelectronic device (10) comprises an optoelectronic circuit (40) including distinct elementary electronic circuits (40ᵢ) connected together, where each elementary electronic circuit (40ᵢ) comprises, on the one hand, one of the sets (Dᵢ) of light-emitting diodes (LEDᵢ) and, on the other hand, a control electronic circuit (16i) ensuring control of the light-emitting diodes (LEDᵢ) of this set (Dᵢ) of light-emitting diodes (LEDi), this control electronic circuit (16ᵢ) being arranged on the side of the second face (13) of the substrate (11) and the electronic component of this set (Dᵢ) of light-emitting diodes (LEDᵢ) forming an integral part of said control electronic circuit (16i).

7. The optoelectronic device (10) according to any one of claims 1 to 6, **characterized in that** the semiconductor elements of the light-emitting diodes (LEDᵢ) of each set (Dᵢ) have a wire-like, conical or frustoconical shape.

8. The optoelectronic device (10) according to any of claims 1 to 7, **characterized in that** at the level of each set (Dᵢ) of light-emitting diodes (LEDᵢ), the first portion (14ᵢ) of the substrate (11) constitutes the first lower electrode and the first conductive means, the first face (12) of the substrate (11) being in contact with the first doped portions of all of the light-emitting diodes (LEDᵢ) of this set (Dᵢ) and the electronic component being in contact with the substrate (11) at the level of its second face (13) so that the electrical connection between the first terminal of the electronic component and the first doped portions of all of the light-emitting diodes (LEDᵢ) of this set (Dᵢ) is ensured by the first portion (14i).

9. The optoelectronic device (10) according to any of claims 1 to 7, **characterized in that** the first conductive means of a given set (Dᵢ) of light-emitting diodes (LEDᵢ) which connects one amongst the first and second electrodes to the first terminal of the electronic component of this set (Dᵢ) is electrically-insulated from the substrate (11) and comprises an electrically-conductive via (25ᵢ) extending from the second face (13) up to the first face (12) of the substrate (11) and electrically connected to the electrode to which the first conductive means is connected.

10. The optoelectronic device (10) according to any of claims 1 to 9, **characterized in that** for each set (Dᵢ) of light-emitting diodes (LEDi), the first lower electrode comprises at least one lower conductive electrode layer (26) formed on the first face (12) of the substrate (11) and in contact with the first doped portions of all of the light-emitting diodes (LEDᵢ) of this set (Dᵢ).

11. A method for manufacturing an optoelectronic device (10) comprising the following steps of:
(a) providing a monolithic substrate (11) delimiting a first face (12) and a second face (13) opposite to one another along the thickness (E) of the substrate (11);
(b) forming a plurality of sets (Dᵢ) of light-emitting diodes (LEDᵢ) where the light-emitting diodes (LEDᵢ) of a given set (Dᵢ) are electrically associated together, step (b) during which the formation of each set (Dᵢ) of light-emitting diodes (LEDᵢ) comprises the formation of a plurality of light-emitting diodes (LEDᵢ), on the side of the first face (12) of the substrate (11), over a corresponding first portion (14ᵢ, 14'ᵢ) of the substrate (11), the formation of each light-emitting diode (LEDᵢ) comprising a step of forming semiconductor elements including a first doped portion, an active portion and a second doped portion;
(c) forming, for each set (Dᵢ) of light-emitting diodes (LEDᵢ), a first lower electrode in contact with the first doped portions of all of the light-emitting diodes (LEDᵢ) of this set (Dᵢ);
(d) forming, for each set (Dᵢ) of light-emitting diodes (LEDi), a second upper electrode in contact with the second doped portions of all of the light-emitting diodes (LEDᵢ) of this set (Dᵢ), the second upper electrode being electrically-insulated with respect to the first lower electrode and comprising a step of forming an upper conductive electrode layer (15) covering at least one portion of each light-emitting diode (LEDᵢ) of this set (Dᵢ) so as to contact with each light-emitting diode (LEDᵢ);
(e) forming an electronic component of an electronic circuit (16ᵢ) in the first portion (14ᵢ, 14'ᵢ) of the substrate (11), on the side of the second face (13) of the substrate (11);
(f) supplying a first conductive means formed through the first portion (14ᵢ, 14'ᵢ) and adapted to electrically connect a first terminal of the electronic component formed at step (e) to the first lower electrode formed at step (c) or to the second upper electrode formed at step (d), step (f) being carried out so that the first conductive means of a given set (Dᵢ) of light-emitting diodes (LEDᵢ) is electrically-insulated from the first conductive means of the other sets (Dᵢ) of light-emitting diodes (LEDᵢ); and
in which the substrate (11) is composed by at least one semiconductor material adapted to serve as a base material for the formation of at least one portion of the electronic component, the method including a sub-step (e1) of step (e) consisting in the formation of said at least one portion of said electronic component from the semiconductor material of the substrate (11) in the first portion (14ᵢ, 14'ᵢ) of the substrate (11), on the side of the second face (13) of the substrate (11).

12. The method according to claim 11, **characterized in that** said at least one portion of said electronic component is an active portion.

13. The method according to any one of claims 11 or 12, **characterized in that** step (a) comprises a step (h) consisting in reducing the thickness of the substrate (11) on the side opposite to the first face (12), the substrate (11) comprising, after step (h), the second face (13) opposite to the first face (12) and **in that** step (h) is carried out before step (e).

14. The method according to any one of claims 11 to 13, **characterized in that** it comprises a step (i) consisting in forming at least one color converter covering the second upper electrode of at least one set (Dᵢ) of light-emitting diodes (LEDᵢ) and **in that** step (e) is carried out at least partially after step (i).

15. The method according to any one of claims 11 to 14, **characterized in that** the second face (13) is a free surface at step (e).
